# EUROPEAN PATENT APPLICATION

(11) **EP 4 773 187 A1**
(43) Date of publication of application: **08.07.2026**
(21) Application number: 24882825.3
(22) Date of filing: 23.10.2024
(51) Int. Cl.: H01L 25/075, H10H 20/857, H10H 20/84, H10D 86/00

(54) **DISPLAY DEVICE AND MANUFACTURING METHOD THEREOF**

(30) Priority: 25.10.2023 KR 20230144170
(71) Applicant: Samsung Display Co., Ltd., Yongin-si, Gyeonggi-do 17113 (KR)
(72) Inventor: CHOI, Jin Woo, Yongin-si Gyeonggi-do 17113 (KR); LEE, Kang Young, Yongin-si Gyeonggi-do 17113 (KR); JEON, Hyung Il, Yongin-si Gyeonggi-do 17113 (KR); TAE, Chang Il, Yongin-si Gyeonggi-do 17113 (KR)
(74) Representative: Walaski, Jan Filip
(86) International application number: PCT/KR2024/016204
(87) International publication number: WO 2025/089798

(57) **Abstract**

A display device includes a substrate, a transistor disposed over the substrate, a first electrode pad electrically connected to the transistor, a first connector disposed on the first electrode pad, an anti-reflection portion arranged around the first connector, and a light-emitting element electrically connected to the first electrode pad through the first connector. Each of the first connector and the anti-reflection portion includes a first material, and a density of the first material included in the first connector may be greater than a density of the first material included in the anti-reflection portion.

## Description

### Technical Field

The invention relates to a display device, particularly to a flexible display device and a manufacturing method thereof.

### Background Art

Along with the development of display devices that visually displays various electrical signals, various display devices having excellent characteristics such as thinness, light weight, low power consumption, and the like have also been introduced. As the demand for display devices providing high-quality images has constantly increased, display devices of various structures have been developed.

### Disclosure of Invention

### Technical Problem

One or more embodiments provide a structure of a display device, for example, a flexible display device, and a manufacturing method thereof.

### Solution to Problem

According to one or more embodiments, a display device includes a substrate, a transistor disposed on the substrate, a first electrode pad electrically connected to the transistor, a first connector disposed on the first electrode pad, an anti-reflection portion arranged around the first connector, and a light-emitting element electrically connected to the first electrode pad through the first connector, wherein each of the first connector and the anti-reflection portion includes a first material, and wherein a density of the first material included in the first connector is greater than a density of the first material included in the anti-reflection portion.

In an embodiment, the density of the first material included in the first connector may be greater than or equal to about twice the density of the first material included in the anti-reflection portion.

In an embodiment, each of the first connector and the anti-reflection portion may include an organic material in which the first material is mixed.

In an embodiment, the first material may include a carbon black.

In an embodiment, an electrical conductivity of the first connector may be greater than an electrical conductivity of the anti-reflection portion.

In an embodiment, the first connector and the anti-reflection portion may be coupled to each other.

In an embodiment, the first connector may be spaced apart from the anti-reflection portion, and a separation region between the first connector and the anti-reflection portion may entirely surround the first connector in a plan view.

In an embodiment, the display device may further include a second electrode pad arranged around the first electrode pad, and a second connector connecting the second electrode pad to the light-emitting element, and including the first material, wherein a density of the first material included in the second connector may be greater than a density of the first material included in the anti-reflection portion.

In an embodiment, the substrate may include an island region in which the light-emitting element is arranged, and a bridge region connecting the island region to an adjacent island region disposed adjacent to the island region, wherein the anti-reflection portion may extend to the bridge region.

According to one or more embodiments, a display device includes a substrate, a transistor disposed on the substrate, a first electrode pad electrically connected to the transistor, a second electrode pad disposed adjacent to the first electrode pad, a light-emitting element disposed on the first electrode pad and the second electrode pad and electrically connected to the first electrode pad and the second electrode pad, and an organic layer disposed between the first electrode pad and the light-emitting element and between the second electrode pad and the light-emitting element, and including a first material, wherein the organic layer includes a first portion overlapping the first electrode pad, a second portion overlapping the second electrode pad, and a third portion not overlapping the first electrode pad and the second electrode pad, where the first portion electrically connects the first electrode pad to the light-emitting element, and the second portion electrically connects the second electrode pad to the light-emitting element.

In an embodiment, a density of the first material included in the first portion may be greater than a density of the first material included in the third portion, and a density of the first material included in the second portion may be greater than a density of the first material included in the third portion.

In an embodiment, an electrical conductivity of the first portion may be greater than an electrical conductivity of the third portion.

In an embodiment, a density of the first material included in the first portion may be greater than or equal to about twice a density of the first material included in the third portion, and a density of the first material included in the second portion may be greater than or equal to about a density of the first material included in the third portion.

In an embodiment, the first material may include a carbon black.

In an embodiment, the first portion may be in contact with the third portion.

In an embodiment, the organic layer may include an opening entirely surrounding the first portion in a plan view.

In an embodiment, the substrate may include an island region in which the light-emitting element is arranged and a bridge region connecting the island region to an adjacent island region disposed adjacent to the island region, wherein the third portion may extend to the bridge region.

According to one or more embodiments, a method of manufacturing a display device includes forming a transistor over a substrate, forming a first electrode pad electrically connected to the transistor, and a second electrode pad adjacent to the first electrode pad, forming an organic layer including a first material on the first electrode pad and the second electrode pad, and disposing a light-emitting element on the organic layer to overlap the first electrode pad and the second electrode pad, and applying a pressure to the light-emitting element such that the light-emitting element is electrically connected to the first electrode pad and the second electrode pad, wherein, in the applying of the pressure, the organic layer includes a first portion, a second portion, and a third portion, wherein the first portion overlaps the first electrode pad and electrically connects the first electrode pad to the light-emitting element, the second portion overlaps the second electrode pad and electrically connects the second electrode pad to the light-emitting element, and the third portion does not overlap the first electrode pad and the second electrode pad, and a density of the first material included in the first portion is greater than a density of the first material included in the third portion, and a density of the first material included in the second portion is greater than a density of the first material included in the third portion.

In an embodiment, an electrical conductivity of the first portion may be greater than an electrical conductivity of the third portion, and an electrical conductivity of the second portion may be greater than the electrical conductivity of the third portion.

In an embodiment, the forming of the organic layer may include patterning the organic layer such that thicknesses of portions of the organic layer overlapping the first electrode pad and the second electrode pad are greater than a thickness of the other portion of the organic layer.

In an embodiment, the forming of the organic layer may include forming a first opening and a second opening, wherein the first opening surrounds a portion of the organic layer that overlaps the first electrode pad, and the second opening surrounds a portion of the organic layer that overlaps the second electrode pad.

In an embodiment, the forming of the organic layer may include forming a single opening surrounding a portion of the organic layer that overlaps the first electrode pad and a portion of the organic layer that overlaps the second electrode pad.

In an embodiment, the first material may include a carbon black.

In an embodiment, the first portion may be coupled to the third portion.

In an embodiment, the substrate may include an island portion in which the light-emitting element is arranged, and a bridge portion connecting the island portion to another island portion around the island portion, wherein the forming of the organic layer may include coating the organic layer to be arranged in the island portion and the bridge portion.

### Advantageous Effects of Invention

According to an embodiment, because the connector and the anti-reflection portion may be formed using the same material, the display device with a simplified manufacturing process and an improved display quality, and the manufacturing process thereof may be provided.

However, this effect is an example, and the invention is not limited by this effect.

### Brief Description of Drawings

The above and other aspects, features, and advantages of embodiments of the invention will be more apparent from the following description taken in conjunction with the accompanying drawings.
FIG. 1 is a schematic perspective view of a display device, according to an embodiment.
FIG. 2A is a perspective view of the display device of FIG. 1 stretched in a first direction, according to an embodiment.
FIG. 2B is a perspective view of the display device of FIG. 1 stretched in a first direction, according to an embodiment.
FIG. 2C is a perspective view of the display device of FIG. 1 stretched in a second direction, according to an embodiment.
FIG. 2D is a perspective view of the display device of FIG. 1 stretched in the first direction and the second direction, according to an embodiment.
FIG. 2E is a perspective view of the display device of FIG. 1 stretched in a third direction, according to an embodiment.
FIG. 3 is a schematic plan view of a display device, according to an embodiment.
FIG. 4A is a view of a portion of a display device showing an enlarged plan view of a region IV of FIG. 3, according to an embodiment.
FIG. 4B is a view of a portion of a display device showing an enlarged plan view of a region IV of FIG. 3, according to an embodiment.
FIG. 4C is a view of a portion of a display showing an enlarged plan view of a region IV of FIG. 3, according to an embodiment.
FIG. 5 is a schematic cross-sectional view of a first island portion and a first bridge portion arranged in a display area of a display device, according to an embodiment.
FIG. 6A is an equivalent circuit diagram of a sub-pixel of a display device, according to an embodiment.
FIG. 6B is an equivalent circuit diagram of a sub-pixel of a display device, according to an embodiment.
FIG. 6C is an equivalent circuit diagram of a sub-pixel of a display device, according to an embodiment.
FIG. 7 is a cross-sectional view of a display device, according to an embodiment.
FIGS. 8A is a cross-sectional view of a light-emitting element and an organic layer corresponding to a region VIII of FIG. 7, according to an embodiment.
FIGS. 8B is a cross-sectional view of a light-emitting element and an organic layer corresponding to a region VIII of FIG. 7, according to an embodiment.
FIG. 9 is a cross-sectional view of a display device, according to an embodiment.
FIG. 10A is a extracted plan view of an organic layer, according to the embodiment of FIG. 9.
FIG. 10B is a extracted plan view of an organic layer according to the embodiment of FIG. 9.
FIG. 11A is a schematic cross-sectional view showing a process of manufacturing a display device, according to an embodiment.
FIG. 11B is a schematic cross-sectional view showing a process of manufacturing a display device, according to an embodiment.
FIG. 11C is a schematic cross-sectional view showing a process of manufacturing a display device, according to an embodiment.
FIG. 11D is a schematic cross-sectional view showing a process of manufacturing a display device, according to an embodiment.
FIG. 11E is a schematic cross-sectional view showing a process of manufacturing a display device, according to an embodiment.
FIG. 12 is a schematic plan view of a display device, according to an embodiment.
FIG. 13 is a schematic cross-sectional view of a first island portion and a first bridge portion of the display device of FIG. 12, according to an embodiment.
FIG. 14 is a schematic plan view of a display device, according to an embodiment.
FIG. 15 is a schematic cross-sectional view of a first island portion and a first bridge portion of the display device of FIG. 14, according to an embodiment.
FIG. 16A is a schematic perspective view of an electronic apparatus including the display device, according to an embodiment.
FIG. 16B is a schematic perspective view of an electronic apparatus including the display device, according to an embodiment.
FIG. 16C is a schematic perspective view of an electronic apparatus including the display device, according to an embodiment.
FIG. 16D is a schematic perspective view of an electronic apparatus including the display device, according to an embodiment.
FIG. 16E is a schematic perspective view of an electronic apparatus including the display device, according to an embodiment.
FIG. 16F is a schematic perspective view of an electronic apparatus including the display device, according to an embodiment.
FIG. 16G is a schematic perspective view of an electronic apparatus including the display device, according to an embodiment

### Best Mode for Carrying out the Invention

According to one or more embodiments, a display device includes a substrate, a transistor disposed on the substrate, a first electrode pad electrically connected to the transistor, a first connector disposed on the first electrode pad, an anti-reflection portion arranged around the first connector, and a light-emitting element electrically connected to the first electrode pad through the first connector, wherein each of the first connector and the anti-reflection portion includes a first material, and wherein a density of the first material included in the first connector is greater than a density of the first material included in the anti-reflection portion.

According to one or more embodiments, a display device includes a substrate, a transistor disposed on the substrate, a first electrode pad electrically connected to the transistor, a second electrode pad disposed adjacent to the first electrode pad, a light-emitting element disposed on the first electrode pad and the second electrode pad and electrically connected to the first electrode pad and the second electrode pad, and an organic layer disposed between the first electrode pad and the light-emitting element and between the second electrode pad and the light-emitting element, and including a first material, wherein the organic layer includes a first portion overlapping the first electrode pad, a second portion overlapping the second electrode pad, and a third portion not overlapping the first electrode pad and the second electrode pad, where the first portion electrically connects the first electrode pad to the light-emitting element, and the second portion electrically connects the second electrode pad to the light-emitting element.

According to one or more embodiments, a method of manufacturing a display device includes forming a transistor over a substrate, forming a first electrode pad electrically connected to the transistor, and a second electrode pad adjacent to the first electrode pad, forming an organic layer including a first material on the first electrode pad and the second electrode pad, and disposing a light-emitting element on the organic layer to overlap the first electrode pad and the second electrode pad, and applying a pressure to the light-emitting element such that the light-emitting element is electrically connected to the first electrode pad and the second electrode pad, wherein, in the applying of the pressure, the organic layer includes a first portion, a second portion, and a third portion, wherein the first portion overlaps the first electrode pad and electrically connects the first electrode pad to the light-emitting element, the second portion overlaps the second electrode pad and electrically connects the second electrode pad to the light-emitting element, and the third portion does not overlap the first electrode pad and the second electrode pad, and a density of the first material included in the first portion is greater than a density of the first material included in the third portion, and a density of the first material included in the second portion is greater than a density of the first material included in the third portion.

### Mode for the Invention

Reference will now be made in detail to embodiments of the invention, examples of which are illustrated in the accompanying drawings, wherein like reference numerals refer to like elements throughout. In this regard, the invention may have different forms and should not be construed as being limited to the descriptions set forth herein. Accordingly, the embodiments are merely described below, by referring to the figures, to explain aspects of the invention. As used herein, the term "and/or" includes any and all combinations of one or more of the associated listed items. "a and/or b" indicates only a, only b, or both a and b. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, one or more embodiments will be illustrated in the drawings and described in the written description. Effects and features of the invention, and methods for achieving them will be clarified with reference to embodiments described below in detail with reference to the drawings. However, the invention is not limited to the following embodiments and may be embodied in various forms.

Hereinafter, embodiments will be described with reference to the accompanying drawings, wherein like reference numerals refer to like elements throughout and a repeated description thereof is omitted.

While such terms as "first" and "second" may be used to describe various elements, such elements must not be limited to the above terms. The above terms are used to distinguish one element from another.

The singular forms used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the invention is not limited thereto.

In the case where a certain embodiment may be implemented differently, a specific process order may be performed in an order different from the described order. As an example, two processes successively described may be simultaneously performed substantially and performed in the opposite order.

It will be understood that when a layer, region, or element is referred to as being "connected" to another layer, region, or element, it may be "directly connected" to the other layer, region, or element or may be "indirectly connected" to the other layer, region, or element with another layer, region, or element located therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element interposed therebetween.

The x-axis, the y-axis and the z-axis are not limited to three axes of the rectangular coordinate system and may be interpreted in a broader sense. For example, the x-axis, the y-axis, and the z-axis may be perpendicular to one another, or may represent different orientations that are not perpendicular to one another.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

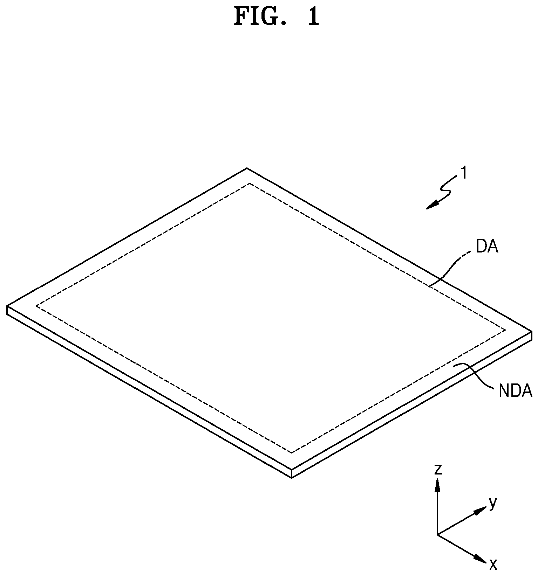

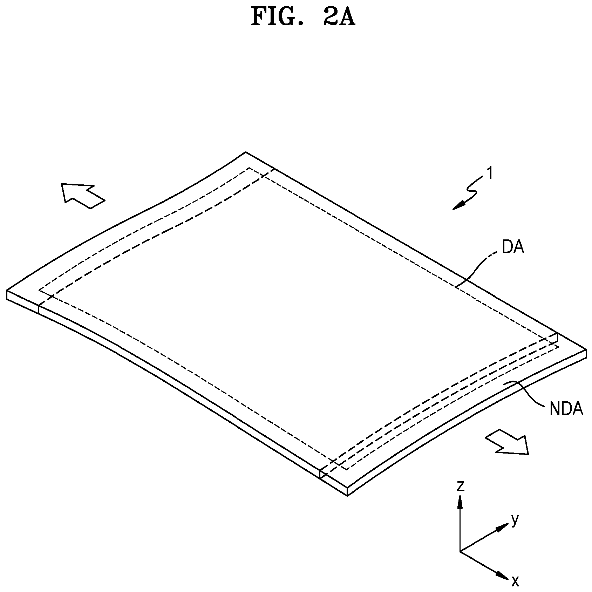

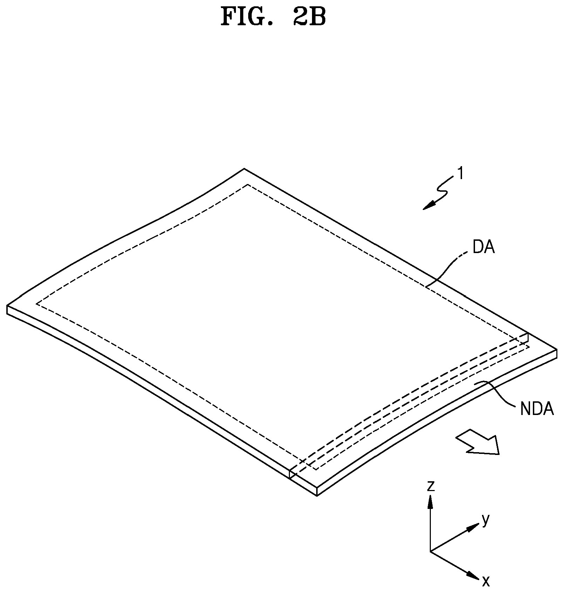

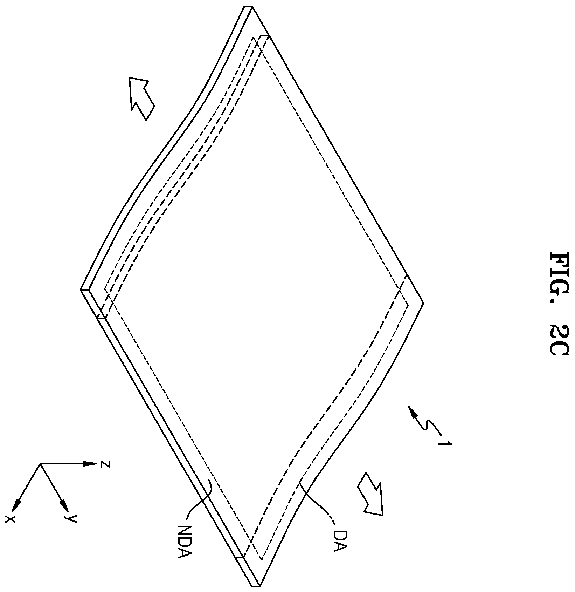

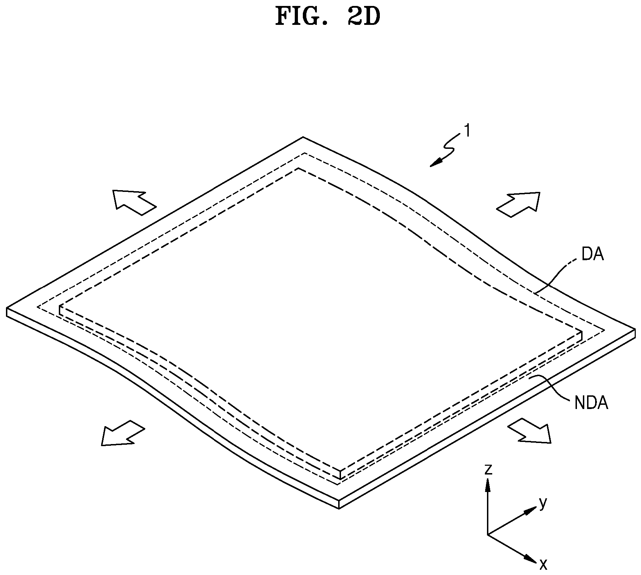

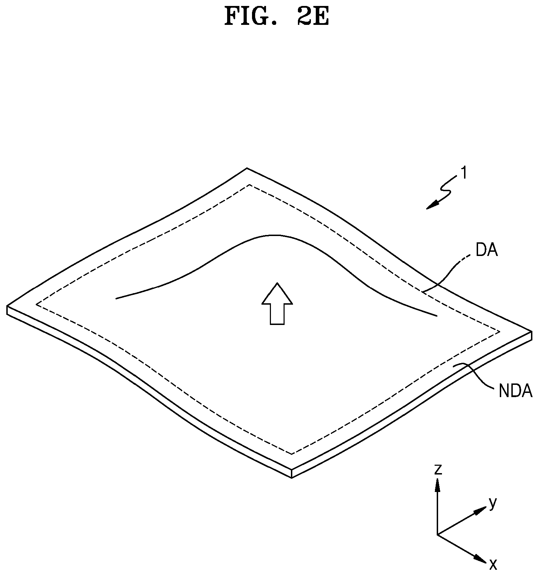

FIG. 1 is a schematic perspective view of a display device 1, according to an embodiment. FIGS. 2A and 2B are perspective views of the display device 1 of FIG. 1 stretched in a first direction, according to an embodiment. FIG. 2C is a perspective view of the display device 1 of FIG. 1 stretched in a second direction, according to an embodiment. FIG. 2D is a perspective view of the display device 1 of FIG. 1 stretched in the first direction and the second direction, according to an embodiment. FIG. 2E is a perspective view of the display device 1 of FIG. 1 stretched in a third direction, according to an embodiment.

In an embodiment and referring to FIG. 1, the display device 1 may include a display area DA and a non-display area NDA. The display area DA may include a plurality of pixels. The display device 1 may be configured to display preset images by using light emitted from the plurality of pixels. The non-display area NDA may be arranged outside the display area DA. The non-display area NDA is a region in which pixels are not arranged and may surround the display area DA entirely.

In an embodiment, the display device 1 may be stretched or unstretched in various directions. The display device 1 may be stretched in the first direction (e.g., an x direction and/or a -x direction) according to external force exerted by an external object or a user. In an embodiment, as shown in FIGS. 2A and 2B, the display area DA and/or the non-display area NDA of the display device 1 may be stretched in the first direction (e.g., the x direction and/or the -x direction). As an example, as shown in FIG. 2A, the display area DA and/or the non-display area NDA may be stretched in the x direction and the -x direction, or be stretched in the x direction with one side of the display device 1 fixed as shown in FIG. 2B.

In an embodiment, the display device 1 may be stretched in the second direction (e.g., a y direction and/or a -y direction) according to external force exerted by an external object or a user. In an embodiment, as shown in FIG. 2C, the display area DA and/or the non-display area NDA of the display device 1 may be stretched in the y direction and/or the -y direction. In another embodiment, the display area DA and/or the non-display area NDA of the display device 1 may be stretched in the y direction or the -y direction with one side of the display device 1 fixed.

In an embodiment, the display device1 may be stretched in a plurality of directions, for example, the first direction (e.g., x direction and/or -x direction) and the second direction (e.g., y direction and/or -y direction) according to external force exerted by an external object or a portion of a person's body. As shown in FIG. 2D, the display area DA and/or the non-display area NDA of the display device 1 may be stretched in ±x directions and ±y directions.

In an embodiment, the display device 1 may be stretched in the third direction (e.g., z direction and/or -z direction) according to external force exerted by an external object or a portion of a person's body. In an embodiment, it is shown in FIG. 2E that a portion of the display device 1, for example, a portion of the display area DA protrudes in the z direction. In another embodiment, a portion of the display device1, for example, a portion of the display area DA protrudes in the -z direction (or is depressed in the z direction).

In an embodiment, although it is shown in FIGS. 2A to 2E that the display device 1 is stretched in the first direction, the second direction, and/or the third direction, the invention is not limited thereto. In another embodiment, the display device 1 may be transformed into various irregular shapes, such as being bent or twisted along two or more axes.

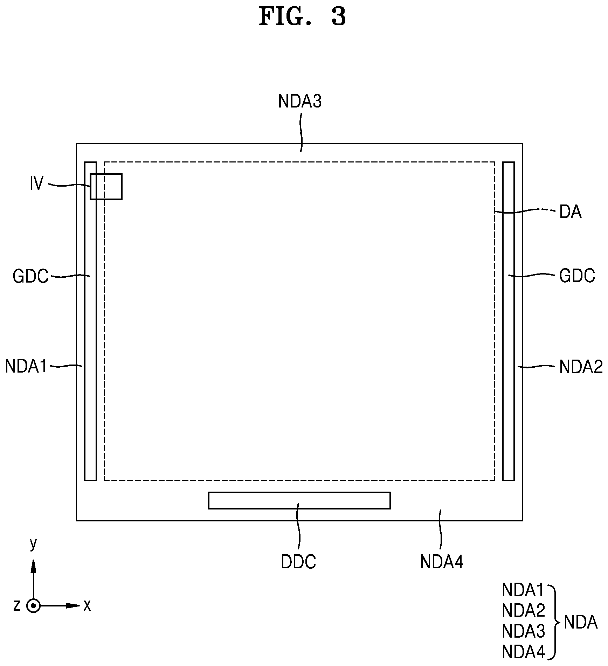

FIG. 3 is a schematic plan view of the display device 1, according to an embodiment.

In an embodiment, a plurality of pixels may be arranged in the display area DA of the display device 1. Each pixel may include sub-pixels configured to emit light of different colors from each other. A light-emitting element corresponding to each sub-pixel may be arranged in the display area DA. A circuit may be arranged in the non-display area NDA around the display area DA, wherein the circuit is configured to provide electrical signals to light-emitting elements arranged in the display area DA and transistors electrically connected to the light-emitting elements. Gate driving circuits GDC may be respectively arranged in a first non-display area NDA1 and a second non-display area NDA2 respectively arranged on two opposite sides with the display area DA therebetween. The gate driving circuit GDC may include drivers configured to provide electrical signals to a gate electrode of each of transistors electrically connected to the light-emitting elements. Although it is shown in FIG. 3 that the gate driving circuits GDC are respectively arranged in the first non-display area NDA1 and the second non-display area NDA2, the invention is not limited thereto. In another embodiment, the gate driving circuit GDC may be arranged in one of the first non-display area NDA1 and the second non-display area NDA2.

In an embodiment, a data driving circuit DDC may be arranged in a third non-display area NDA3 and/or a fourth non-display area NDA4 connecting the first non-display area NDA1 to the second non-display area NDA2. In an embodiment, it is shown in FIG. 3 that the data driving circuit DDC is arranged in the fourth non-display area NDA4. In another embodiment, the data driving circuits DDC may be respectively arranged in the third non-display area NDA3 and the fourth non-display area NDA4.

In an embodiment, although it is shown in FIG. 3 that the data driving circuit DDC is arranged in the fourth non-display area NDA4 of the display device 1, the invention is not limited thereto. In another embodiment, the display device 1 may further include a flexible circuit board (not shown) electrically connected thereto through a terminal portion (not shown) arranged in the fourth non-display area NDA4. The data driving circuit DDC may be arranged in the flexible circuit board.

In an embodiment, an elongation rate of the non-display area NDA may be equal to or less than an elongation rate of the display area DA. In an embodiment, the elongation rate of the non-display area NDA may be different for each region thereof. As an example, although the first non-display area NDA1, the second non-display area NDA2, and the third non-display area NDA3 may have substantially the same elongation rate, the elongation rate of the fourth non-display area NDA4 may be less than the elongation rate of each of the first non-display area NDA1, the second non-display area NDA2, and the third non-display area NDA3.

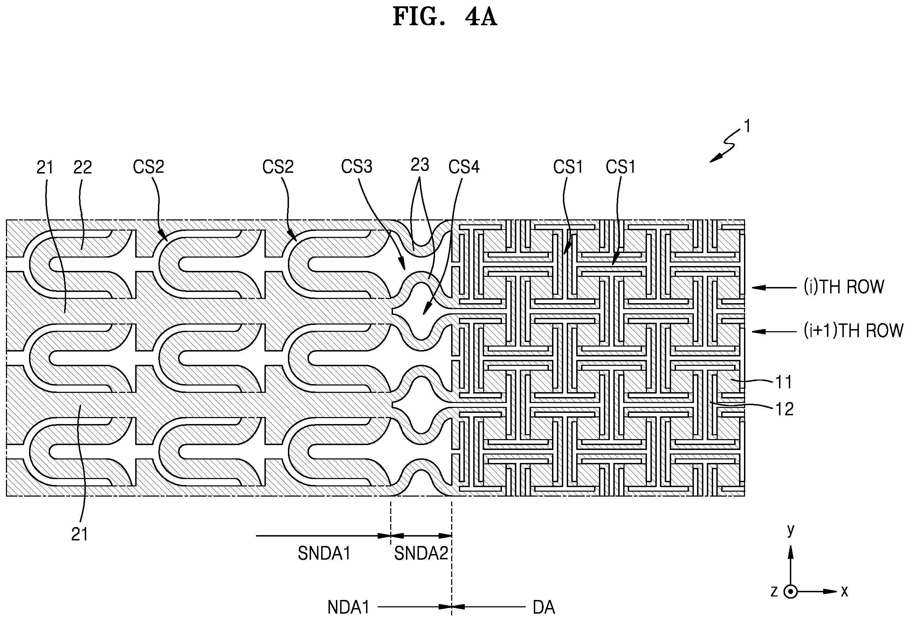

FIG. 4A is a view of a portion of the display device 1, according to an embodiment and an enlarged plan view of a region IV of FIG. 3.

In an embodiment and referring to FIG. 4A, the display device 1 may include first island portions 11 and first bridge portions 12 connecting adjacent first island portions 11, wherein the first island portions 11 are spaced apart from each other in the first direction (e.g., x direction or -x direction) and the second direction (e.g., y direction or -y direction) in the display area DA.

In an embodiment, each first island portion 11 may be connected to a plurality of first bridge portions 12. As an example, each first island portion 11 may be connected to four first bridge portions 12. Two first bridge portions 12 may be respectively arranged on two opposite sides of the first island portion 11 in the first direction (e.g., x direction or -x direction), and two remaining first bridge portions 12 may be respectively arranged on two opposite sides of the first island portion 11 in the second direction (e.g., y direction or -y direction). In an embodiment, four first bridge portions 12 may be respectively connected to four lateral sides of the first island portion 11. Each of the four first bridge portions 12 may be disposed adjacent to each of the corners of the first island portion 11.

In an embodiment, the first bridge portions 12 may be spaced apart from each other by a first opening CS1 arranged between the first bridge portions 12. In an embodiment, a first opening CS1 of an approximate H shape and a first opening CS1 of an approximate I shape that is rotated by 90° from the H shape may be alternately and repeatedly arranged in the first direction (e.g., x direction or -x direction) and the second direction (e.g., y direction or -y direction). Two opposite ends of each first bridge portion 12 may be respectively connected to adjacent first island portions 11, and one side of each first bridge portion 12 may be spaced apart from one side of an adjacent first island portion 11 and/or one side of another first bridge portion 12 by the first opening CS1.

In an embodiment, the display device 1 may include second islands 21 spaced apart from each other, and second bridge portions 22 connecting adjacent second island portions 21 in the non-display area, for example, the first non-display area NDA1 shown in FIG. 4A.

In an embodiment, each second island portion 21 may extend in the first direction (e.g., x direction or -x direction). The second island portions 21 may be apart from each other in the second direction (e.g., y direction or -y direction) crossing the first direction (e.g., x direction or -x direction). Each second island portion 21 may include drivers of the gate driving circuit GDC (see FIG. 2) described with reference to FIG. 3.

In an embodiment, the second bridge portion 22 may have a serpentine shape. The length of the second bridge portion 22 may be greater than a shortest distance between adjacent second island portions 21 in the second direction (e.g., y direction or - y direction). In an embodiment, the second bridge portion 22 may have an approximate omega Ω shape convex in the first direction (e.g., x direction or -x direction). The second bridge portions 22 may be arranged between adjacent second island portions 21 and be apart from each other.

In an embodiment, the second bridge portions 22 disposed between adjacent second island portions 21 may be spaced apart from each other by a second opening CS2. Between adjacent second island portions 21, the second openings CS2 and the second bridge portions 22 may be alternately arranged in the first direction (e.g., x direction or -x direction). The second openings CS2 may have the same shape. Two opposite ends of each second bridge portion 22 may be respectively connected to adjacent second island portions 21, and one side of each second bridge portion 22 may be spaced apart from one side of an adjacent second island portion 21 and/or one side of another second island portion 22 by the second opening CS2.

In an embodiment, one second island portion 21 arranged in the first non-display area NDA1 may correspond to the first island portions 11 in a plurality of rows arranged in the display area DA. As an example, one second island portion 21 arranged in the first non-display area NDA1 may correspond to the first island portions 11 in an (i)th row and the first island portions 11 in an (i+1)th row in the display area DA (here, i is a positive number greater than 0). Although it is shown in FIG. 4A that one second island portion 21 corresponds to two rows of the first island portions 11, the embodiment is not limited thereto. In another embodiment, one second island portion 21 arranged in the first non-display area NDA1 may correspond to n rows of the first island portions 11 arranged in the display area DA (here, n is a positive number greater than or equal to 3).

In an embodiment, the non-display area, for example, the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridge portions 23 may be arranged in the second sub-non-display area SNDA2, wherein the third bridge portions 23 connects the display area DA to the first sub-non-display area SNDA1. One end of the third bridge portion 23 may be connected to the second island portion 21 and/or the second bridge portion 22, and the other end of the third bridge portion 23 may be connected to the first island portion 11 and/or the first bridge portion 12.

In an embodiment, the third bridge portion 23 may have a serpentine shape. In an embodiment, the shape of the third bridge portion 23 may be different from the shape of each of the first bridge portion 12 and the second bridge portion 22. In an embodiment, as shown in FIG. 4A, the third bridge portion 23 may have an approximate omega Ω shape convex in the second direction (e.g., the y direction or the -y direction). The third bridge portions 23 may have a structure that is symmetrical to each other, such that one of the adjacent third bridge portions 23 arranged in the second direction (for example, y direction or -y direction) is convex in the y direction and the other is convex in the -y direction. A structure in which third openings CS3 and fourth openings CS4 of different shapes are repeated may be provided between the third bridge portions 23. The width of the third bridge portion 23 may be different from the width of the first bridge portion 12 and the width of the second bridge portion 22. In an embodiment, the width of the third bridge portion 23 may be greater than the width of the first bridge portion 12 and less than the width of the second bridge portion 22.

In an embodiment, it is shown in FIG. 4A that the second island portion 21 and the second bridge portion 22 in the non-display area NDA, for example, the first non-display area NDA1, respectively have shapes different from the shapes of the first island portion 11 and the first bridge portion 12 in the display area DA. In another embodiment, the second island portion 21 and the second bridge portion 22 in the non-display area NDA may have the same shapes as the first island portion 11 and the first bridge portion 12 in the display area DA.

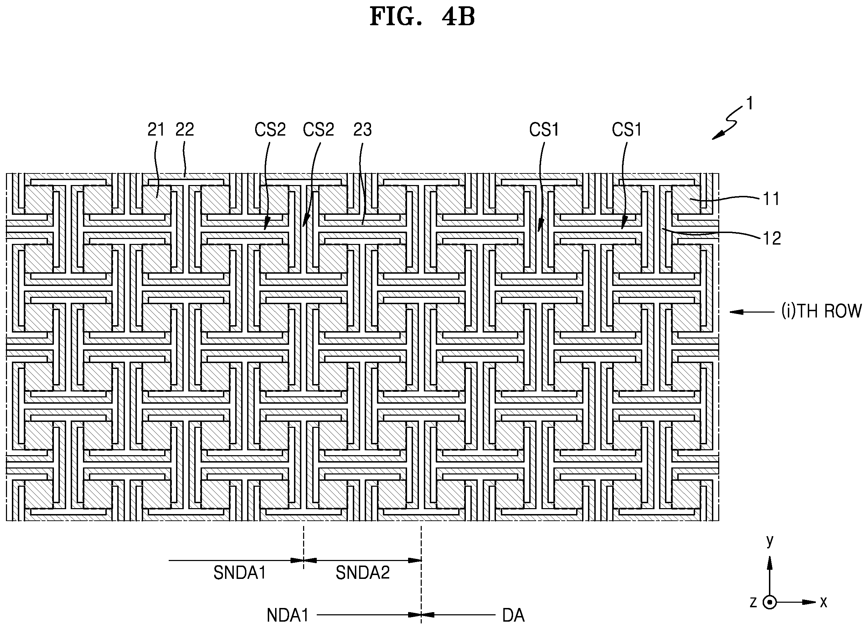

FIG. 4B is an enlarged plan view of a portion of the display device 1 and a region IV of FIG. 3, according to an embodiment.

In an embodiment and referring to FIG. 4B, the display device 1 includes the first island portions 11 spaced apart from each other, and the first bridge portions 12 in the display area DA, wherein the first bridge portions 12 are spaced apart from each other by the first opening CS1 and connects adjacent first island portions 11. The structure of the display area DA in FIG. 4B may be the same as the structure of the display area DA described above with reference to FIG. 4A.

In an embodiment, the display device 1 may include the second island portions 21 and the second bridge portions 22 arranged in the non-display area, for example, the first non-display area NDA1. In an embodiment, the second island portions 21 and the second bridge portions 22 may respectively have substantially the same shapes as the first island portions 11 and the first bridge portions 12.

In an embodiment, the second island portions 21 may be spaced apart from each other in the first direction (e.g., x direction or -x direction) and the second direction (for example, y direction or -y direction) in the non-display area, for example, the first non-display area NDA1. Each of the second bridge portions 22 may connect adjacent second island portions 21. The second bridge portions 22 may be apart from each other by the second opening CS2 arranged between the second bridge portions 22.

In an embodiment, the second opening CS2 may have the substantially same shape as the first opening CS1. As an example, the second opening CS2 having an approximate H shape and the second opening CS2 having an approximate I shape may be alternately and repeatedly arranged in the non-display area, for example, the first non-display area NDA1. Two opposite ends of each second bridge portion 22 may be respectively connected to adjacent second island portions 21, and one side of each second bridge portion 22 may be spaced apart from one side of an adjacent second island portion 21 and/or one side of another second bridge portion 22 by the second opening CS2.

In an embodiment, each second island portion 21 may be connected to four second bridge portions 22. Each second island portion 21 may include drivers of the gate driving circuit GDC (see FIG. 2) described with reference to FIG. 3.

In an embodiment, the second island portions 21 arranged in one row in the first non-display area NDA1 may correspond to the first island portions 11 in one row arranged in the display area DA. As an example, the second island portions 21 arranged in the (i)th row in the first direction (e.g., the x direction or the -x direction) in the first non-display area NDA1 may correspond to the first island portions 11 arranged in the same row, for example, an (i)th row in the display area DA (here, i is a positive number greater than 0).

In an embodiment, the display device 1 may include the third bridge portions 23 arranged in the second sub-non-display area SNDA2, wherein the third bridge portions 23 connect the display area DA to the first sub-non-display area SNDA1. The non-display area, for example, the first non-display area NDA1 may include the first sub-non-display area SNDA1 in which the second island portions 21 and the second bridge portions 22 are arranged, and the second sub-non-display area SNDA2 including the third bridge portions 23 and arranged between the first sub-non-display area SNDA1 and the display area DA. The third bridge portion 23 may be substantially the same as the first bridge portion 12 and the second bridge portion 22. As an example, the width of the third bridge portion 23 may be the same as the width of the first bridge portion 12 and the width of the second bridge portion 22.

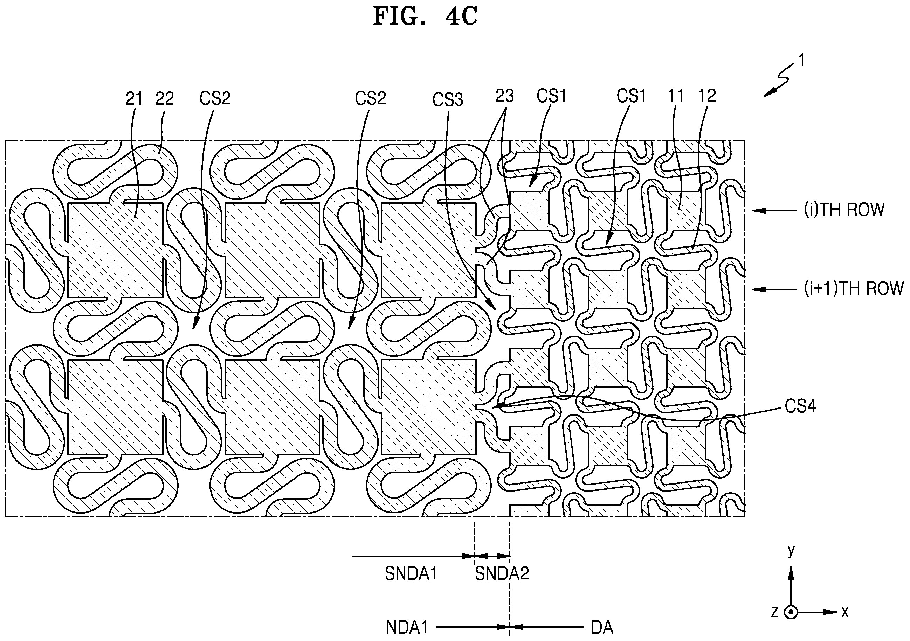

FIG. 4C is a view of a portion of the display device 1 and an enlarged plan view of a region IV of FIG. 3, according to an embodiment.

In an embodiment and referring to FIG. 4C, the display device 1 may include first island portions 11 and first bridge portions 12, wherein the first island portions 11 are apart from each other in the first direction (e.g., the x direction or the -x direction) and the second direction (e.g., the y direction or the -y direction), and the first bridge portions 12 connect adjacent first island portions 11 in the display area DA.

In an embodiment, the first bridge portions 12 may be spaced apart from each other by the first opening CS1 arranged between the first bridge portions 12. The first bridge portion 12 may have a serpentine shape. As an example, as shown in FIG. 4C, the first bridge portion 12 may have a shape of approximate 'alphabet S'.

In an embodiment, each first island portion 11 may be connected to a plurality of first bridge portions 12. As an example, each first island portion 11 may be connected to four first bridge portions 12. Two first bridge portions 12 may be respectively arranged on two opposite sides of the first island portion 11 in the first direction (e.g., x direction or -x direction), and two remaining first bridge portions 12 may be respectively arranged on two opposite sides of the first island portion 11 in the second direction (e.g., y direction or -y direction). The four first bridge portions 12 may be respectively connected to four sides of the first island portion 11. Each of the four first bridge portions 12 may be disposed adjacent to each of the corners of the first island portion 11.

In an embodiment, the display device 1 may include the second island portions 21 and the second bridge portions 22 connecting adjacent second island portions 21, wherein the second island portions 21 are apart from each other in the first direction (e.g., the x direction or the -x direction) and the second direction (e.g., the y direction or the -y direction) in the first non-display area NDA1 shown in FIG. 4C.

In an embodiment, the second bridge portions 22 may be spaced apart from each other by the second opening CS2 arranged between the second bridge portions 22. The second bridge portion 22 may have a serpentine shape. In an embodiment, as shown in FIG. 4C, the second bridge portion 22 may have a shape of approximate 'alphabet S'. The size and/or width of the second bridge portion 22 may be different from the size and/or width of the first bridge portion 12. In an embodiment, the size and/or width of the second bridge portion 22 may be greater than the size and/or width of the first bridge portion 12. A radius of curvature of a rounded portion of the second bridge portion 22 may be different from a radius of curvature of a rounded portion of the first bridge portion 12. In an embodiment the radius of curvature of a rounded portion of the second bridge portion 22 may be greater than the radius of curvature of a rounded portion of the first bridge portion 12.

In an embodiment, each second island portion 21 may be connected to a plurality of second bridge portions 22. Each second island portion 21 may be connected to four second bridge portions 22. Two second bridge portions 22 may be respectively arranged on two opposite sides of the second island portion 21 in the first direction (e.g., the x direction or the -x direction), and the remaining two second bridge portions 22 may be respectively arranged on two opposite sides of the second island portion 21 in the second direction (e.g., the y direction or the -y direction). In an embodiment, four second bridge portions 22 may be respectively connected to four sides of the second island portion 21. Each second bridge portion 22 may be connected to the central portion of each side of the second island portion 21.

In an embodiment, the second island portions 21 in one row arranged in the first non-display area NDA1 may correspond to the first island portions 11 in a plurality of rows arranged in the display area DA. As an example, the second island portions 21 in one row arranged in the first non-display area NDA1 may correspond to the first island portions 11 in an (i)th row and the first island portions 11 in an (i+1)th row in the display area DA (here, i is a positive number greater than 0). In another embodiment, the second island portions 21 in one row may correspond to n rows of the first island portions 11 (here, n is a positive number greater than or equal to 3).

In an embodiment, the non-display area, for example, the first non-display area NDA1 may include a first sub-non-display area SNDA1 in which the second island portions 21 and the second bridge portions 22 are arranged, and a second sub-non-display area SNDA2 between the first sub-non-display area SNDA1 and the display area DA. Third bridges 23 may be arranged in the second sub-non-display area SNDA2, wherein the third bridge portions 23 connects the display area DA to the first sub-non-display area SNDA1. One end of the third bridge portion 23 may be connected to the second island portion 21, and the other end of the third bridge portion 23 may be connected to the first island portion 11. As an example, one end of the third bridge portion 23 may be connected to the central portion of one side of the second island portion 21, and the other end of the third bridge portion 23 may be connected to the central portion of one side of the first island portion 11.

In an embodiment, the third bridge portion 23 may have a serpentine shape. In an embodiment, the shape of the third bridge 23 may be different from the shape of each of the first bridge portion 12 and the second bridge portion 22. The width of the third bridge portion 23 may be different from the width of the first bridge portion 12 and the width of the second bridge portion 22. The width of the third bridge portion 23 may be greater than the width of the first bridge portion 12 and less than the width of the second bridge portion 22. In the second direction (e.g., the y direction or the -y direction), the third openings CS3 and the fourth openings CS4 having different shapes may be alternately arranged between the third bridge portions 23.

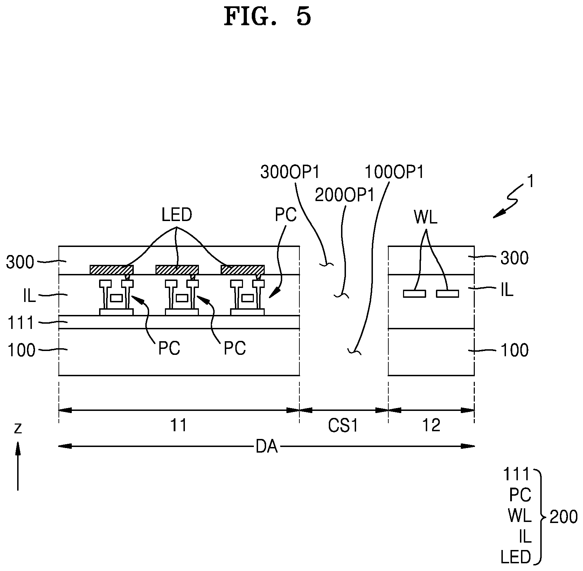

FIG. 5 is a schematic cross-sectional view of the first island portion 11 and the first bridge portion 12 arranged in the display area DA of the display device 1, according to an embodiment.

In an embodiment and referring to FIG. 5, the first island portion 11 and the first bridge portion 12 arranged in the display area DA may be spaced apart from each other with the first opening CS1 therebetween. The first island portion 11 may include light-emitting elements LED and a circuit, for example, a pixel driving circuit PC electrically connected to the light-emitting elements LED and configured to drive light-emitting elements. The bridge portion 12 may include a wiring WL electrically connected to the pixel driving circuits PC respectively arranged on adjacent first island portions 11.

In an embodiment, the first island portion 11 is described as follows, in which a buffer layer 111 including an inorganic insulating material may be disposed on a substrate 100, and the pixel driving circuit PC may be disposed on the buffer layer 111. An insulating layer IL including an inorganic insulating material and/or an organic insulating material may be disposed between the pixel driving circuit PC and the light-emitting element LED. The light-emitting element LED may be disposed on the insulating layer IL and electrically connected to the pixel driving circuit PC. The light-emitting elements LED may be configured to emit light of different colors or emit light of the same color. In an embodiment, the light-emitting elements LED may be configured to respectively emit red, green, and blue light. In an embodiment, the light-emitting elements LED may be configured to emit white light. In another embodiment, the light-emitting elements LED may be configured to respectively emit red, green, blue, and white light.

In an embodiment, the substrate 100 may include polymer resin such as polyethersulfone, polyarylate, polyetherimide, polyethylene naphthalate, polyethylene terephthalate, polyphenylene sulfide, polyimide, polycarbonate, cellulose tri acetate, and cellulose acetate propionate. In an embodiment, the substrate 100 may include a single layer including the polymer resin. In another embodiment, the substrate 100 may have a multi-layered structure including a base layer and a barrier layer, wherein the base layer includes the above polymer resin and the barrier layer includes an inorganic insulating material. The substrate 100 including the polymer resin is flexible, rollable, or bendable.

In an embodiment, although it is shown in FIG. 5 that three pixel driving circuit portions PC are arranged in the first island portion 11 and three light-emitting elements LED are respectively connected to the pixel driving circuit portions PC, the invention is not limited thereto. In another embodiment, the number of pixel driving circuit portions PC and the number of light-emitting elements LED arranged in the first island portion 11 may be one, two, four, or more.

In an embodiment, an encapsulation layer 300 may be disposed on the light-emitting element LED and may protect the light-emitting element LED from external force and/or moisture transmission. The encapsulation layer 300 may include an inorganic encapsulation layer and/or an organic encapsulation layer. In an embodiment, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In an embodiment, the encapsulation layer 300 may include urethane epoxy acrylate. The encapsulation layer 300 may include a photosensitive material, for example, a photoresist.

In an embodiment, the first bridge portion 12 is described as follows, in which: the insulating layer IL including an organic insulating material may be disposed on the substrate 100. Unlike the first island portion 11, the first bridge portion 12, which is relatively transformed much when the display device 1 is stretched, may not include a layer including an inorganic insulating material that is prone to cracks.

In an embodiment, the substrate 100 corresponding to the first bridge portion 12 may have the same stack structure as the substrate 100 corresponding to the first island portion 11. For example, the substrate 100 corresponding to the first bridge portion 12 and the substrate 100 corresponding to the first island portion 11 may include polymer resin layers simultaneously formed during the same process. In another embodiment, the substrate 100 corresponding to the first bridge portion 12 may have a stack structure different from the substrate 100 corresponding to the first island portion 11. For example, the substrate 100 corresponding to the first bridge portion 12 may have a multi-layered structure including a base layer including polymer resin and a barrier layer including an inorganic insulating material, and the substrate 100 corresponding to the first bridge portion 12 may have a structure of a polymer resin layer without a layer including an inorganic insulating material.

In an embodiment, as described above, the wirings WL of the first bridge portion 12 may be signal lines (e.g., a gate line, a data line, and the like) configured to provide electrical signals to transistors included in the pixel driving circuit PC of the first island portion 11, or voltage lines (e.g., a driving voltage line, an initialization voltage line, and the like) configured to provide voltages. The encapsulation layer 300 may be disposed also on the first bridge portion 12. In another embodiment, the encapsulation layer 300 may not be present in the first bridge portion 12.

In an embodiment and referring to FIGS. 4A to 4C, and 5, the substrate 100 corresponding to the first island portion 11 and the substrate 100 corresponding to the first bridge portion 12 may be connected to each other. In other words, the plan views shown above in FIGS. 4A to 4C may be substantially same as the plan view of the substrate 100 of FIG. 5. In other words, the substrate 100 may include a region corresponding to the first island portion 11, a region corresponding to the first bridge portion 12, and an opening 100OP1 having a shape equal to the shape of the first opening CS1.

In an embodiment, the encapsulation layer 300 corresponding to the first island portion 11 and the encapsulation layer 300 corresponding to the first bridge portion 12 may be connected to each other. As an example, the plan views shown above in FIGS. 4A to 4C may be substantially the same as the plan view of the encapsulation layer 300. In other words, the encapsulation layer 300 may include a region corresponding to the first island portion 11, a region corresponding to the first bridge portion 12, and an opening 300OP1 having a shape equal to the shape of the first opening CS1.

In an embodiment, a circuit-light-emitting element layer 200 disposed between the substrate 100 and the encapsulation layer 300 may include the pixel driving circuit PC, the wiring WL, the insulating layer IL, and the light-emitting element LED. Similar to the substrate 100, the plan views shown above in FIGS. 4A to 4C may be substantially the same as the plan view of the circuit-light-emitting element layer 200. In other words, the circuit-light-emitting element layer 200 may include an opening 200OP1 having a shape equal to the first opening CS1.

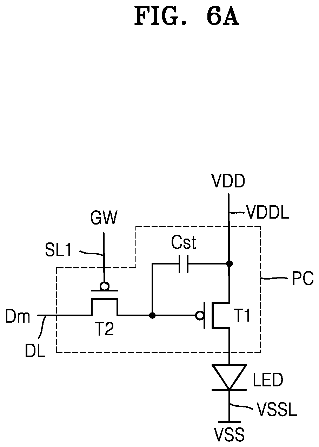

FIGS. 6A to 6C are equivalent circuit diagrams of a sub-pixel of the display device 1, according to an embodiment.

In an embodiment and referring to FIG. 6A, the light-emitting element LED corresponding to the sub-pixel may be electrically connected to the pixel driving circuit PC, and the pixel driving circuit PC may include a first transistor T1, a second transistor T2, and a storage capacitor Cst. The pixel driving circuit PC may be electrically connected to the signal lines and the voltage lines. The signal lines may include a gate line such as a first scan line SL1, and a data line DL. The voltage lines may include a first voltage line VDDL.

In an embodiment, the second transistor T2 may be electrically connected to the first scan line SL1 and the data line DL. The first scan line SL1 may be configured to provide a first scan signal GW to a gate electrode of the second transistor T2. The second transistor T2 may be configured to transfer a data signal Dm to the first transistor T1 according to a first scan signal GW input from the first scan line SL1, wherein the data signal Dm is input from the data line DL.

In an embodiment, the storage capacitor Cst may be electrically connected to the second transistor T2 and a first voltage line VDDL and configured to store a voltage corresponding to a difference between a voltage transferred from the second transistor T2 and a first power voltage VDD supplied by the first voltage line VDDL.

In an embodiment, the first transistor T1 is a driving transistor and may be configured to control a driving current flowing through the light-emitting element LED. The first transistor T1 may be connected to the first voltage line VDDL and the storage capacitor Cst. The first transistor T1 may be configured to control the driving current flowing from the first voltage line VDDL to the light-emitting element LED in response to a voltage value stored in the storage capacitor Cst. The light-emitting element LED may be configured to emit light having a preset brightness based on the driving current. A first electrode of the light-emitting element LED may be electrically connected to the first transistor T1, and a second electrode of the light-emitting element LED may be electrically connected to a second voltage line VSSL configured to supply a second power voltage VSS.

In an embodiment, although it is shown in FIG. 6A that the pixel driving circuit PC includes two transistors and one storage capacitor, the pixel driving circuit PC may include three or more transistors.

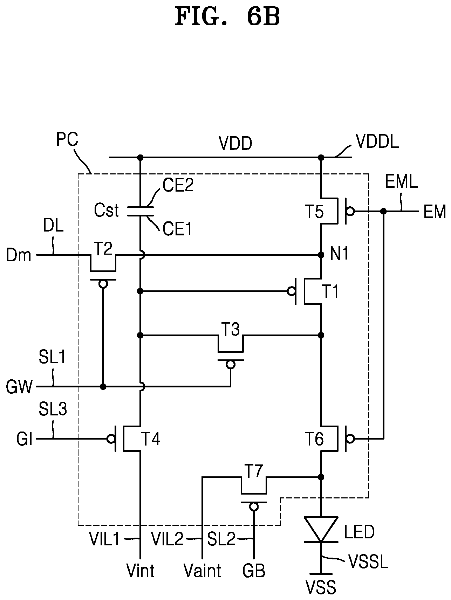

In an embodiment and referring to FIG. 6B, the pixel driving circuit PC may include the first transistor T1, the second transistor T2, a third transistor T3, a fourth transistor T4, a fifth transistor T5, a sixth transistor T6, a seventh transistor T7, and the storage capacitor Cst.

In an embodiment, the pixel driving circuit PC is electrically connected to the signal lines and the voltage lines. The signal lines may include the first scan line SL1, a second scan line SL2, a third scan line SL3, the gate line such as an emission control line EML, and the data line DL. The voltage lines may include first and second initialization voltage lines VIL1 and VIL2 and the first voltage line VDDL.

In an embodiment, the first voltage line VDDL may be configured to transfer the first power voltage VDD to the first transistor T1. The first initialization voltage line VIL1 may be configured to transfer a first initialization voltage Vint to the pixel driving circuit PC, wherein the first initialization voltage Vint initializes the first transistor T1. The second initialization voltage line VIL2 may be configured to transfer a second initialization voltage Vaint to the pixel driving circuit PC, wherein the second initialization voltage Vaint initializes the first electrode of the light-emitting element LED.

In an embodiment, the first transistor T1 may be electrically connected to the first voltage line VDDL through the fifth transistor T5, and electrically connected to the light-emitting element LED through the sixth transistor T6. The first transistor T1 serves as the driving transistor, receives a data signal Dm, and supplies the driving current to the light-emitting element LED according to a switching operation of the second transistor T2.

In an embodiment, the second transistor T2 serves as a data-write transistor and is electrically connected to the first scan line SL1 and the data line DL. The second transistor T2 may be connected to the first voltage line VDDL through the fifth transistor T5. The second transistor T2 is turned on according to a first scan signal GW transferred through the first scan line SL1 and performs a switching operation of transferring a data signal Dm to a first node N1, the data signal Dm being transferred through the data line DL.

In an embodiment, the third transistor T3 is electrically connected to the first scan line SL1 and electrically connected to the light-emitting element LED through the sixth transistor T6. The third transistor T3 may be turned on according to a first scan signal GW to diode-connect the first transistor T1, wherein the first scan signal GW is transferred through the first scan line SL1.

In an embodiment, the fourth transistor T4 serves as a first initialization transistor and is electrically connected to the third scan line SL3 and the first initialization voltage line VIL1. The fourth transistor T4 may be turned on according to a third scan signal GI to initialize a gate voltage of the first transistor T1 by transferring the first initialization voltage Vint to the gate electrode of the first transistor T1, wherein the initialization voltage Vint is from the first initialization voltage line VIL1, and the third scan signal GI is transferred through the third scan line SL3. A third scan signal GI may correspond to a first scan signal of another pixel driving circuit arranged in a previous row of the relevant pixel driving circuit portion.

In an embodiment, the fifth transistor T5 may be an operation control transistor, and the sixth transistor T6 may be an emission control transistor. The fifth transistor T5 and the sixth transistor T6 may be electrically connected to the emission control line EML, simultaneously turned on according to an emission control signal EM transferred through the emission control line EML and may form a current path such that the driving current flows in a direction from the first voltage line VDDL to the light-emitting element LED.

In an embodiment, the seventh transistor T7 serves as a second initialization transistor and may be electrically connected to the second scan line SL2, the second initialization voltage line VIL2, and the sixth transistor T6. The seventh transistor T7 is turned on according to a second scan signal GB transferred through the second scan line SL2 and is configured to transfer the second initialization voltage Vaint from the second initialization voltage line VIL2 to the first electrode of the light-emitting element LED, thereby initializing the first electrode of the light-emitting element LED.

In an embodiment, the storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a difference between voltages of two opposite ends of the gate electrode of the first transistor T1 and the first voltage line VDDL.

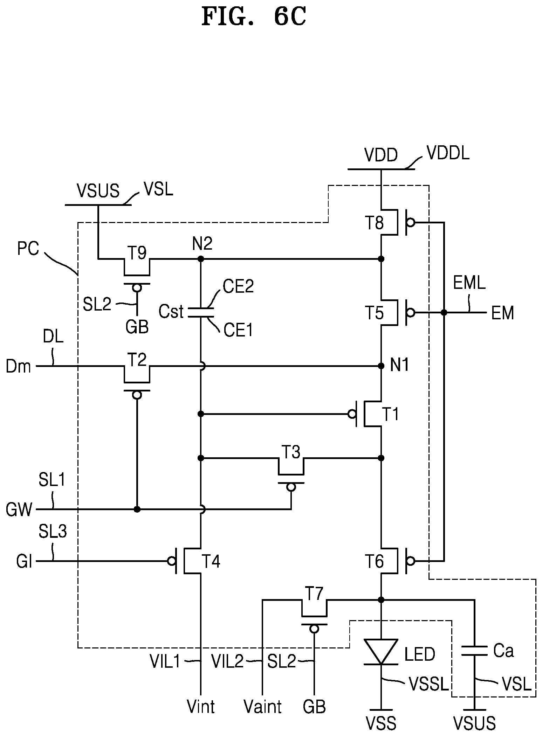

In an embodiment and referring to FIG. 6C, the pixel driving circuit PC may include the first transistor T1, the second transistor T2, the third transistor T3, the fourth transistor T4, the fifth transistor T5, the sixth transistor T6, the seventh transistor T7, an eighth transistor T8, a ninth transistor T9, the storage capacitor Cst and an auxiliary capacitor Ca.

In an embodiment, the pixel driving circuit PC is electrically connected to the signal lines and the voltage lines. The signal lines may include the first scan line SL1, the second scan line SL2, the third scan line SL3, the gate line such as the emission control line EML, and the data line DL. The voltage lines may include the first and second initialization voltage lines VIL1 and VIL2, a sustain voltage line VSL, and the first voltage line VDDL.

In an embodiment, the first voltage line VDDL may be configured to transfer the first power voltage VDD to the first transistor T1. The first initialization voltage line VIL1 may be configured to transfer the first initialization voltage Vint to the pixel driving circuit PC, wherein the first initialization voltage Vint initializes the first transistor T1. The second initialization voltage line VIL2 may be configured to transfer the second initialization voltage Vaint to the pixel driving circuit PC, wherein the second initialization voltage Vaint initializes the first electrode of the light-emitting element LED. The sustain voltage line VSL may be configured to provide a sustain voltage VSUS to a second node N2, for example, the second electrode CE2 of the storage capacitor Cst during an initialization section and a data-write section.

In an embodiment, the first transistor T1 may be electrically connected to the first voltage line VDDL through the fifth transistor T5 and the eighth transistor T8, and electrically connected to the light-emitting element LED through the sixth transistor T6. The first transistor T1 serves as the driving transistor, receives a data signal Dm, and may supply the driving current to the light-emitting element LED according to a switching operation of the second transistor T2.

In an embodiment, the second transistor T2 is electrically connected to the first scan line SL1 and the data line DL and electrically connected to the first voltage line VDDL through the fifth transistor T5 and the eighth transistor T8. The second transistor T2 may be turned on according to a first scan signal GW transferred through the first scan line SL1 and may perform a switching operation of transferring a data signal Dm to the first node N1, wherein the data signal Dm is transferred through the data line DL.

In an embodiment, the third transistor T3 is electrically connected to the first scan line SL1 and electrically connected to the light-emitting element LED through the sixth transistor T6. The third transistor T3 may be turned on according to a first scan signal GW to compensate for a threshold voltage of the first transistor T1 by diode-connecting the first transistor T1, wherein the first scan signal GW is transferred through the first scan line SL1.

In an embodiment, the fourth transistor T4 is electrically connected to the third scan line SL3 and the first initialization voltage line VIL1, turned on according to a third scan signal GI transferred through the third scan line SL3, and initializes the voltage of the gate electrode of the first transistor T1 by transferring the initialization voltage Vint to the gate electrode of the first transistor T1, wherein the initialization voltage Vint is from the first initialization voltage line VIL1. The third scan signal GI may correspond to a first scan signal of another pixel driving circuit arranged in a previous row of the relevant pixel driving circuit.

In an embodiment, the fifth transistor T5, the sixth transistor T6, and the eighth transistor T8 may be electrically connected to the emission control line EML, simultaneously turned on according to an emission control signal EM transferred through the emission control line EML, and may form a current path such that the driving current flows in a direction from the first voltage line VDDL to the light-emitting element LED.

In an embodiment, the seventh transistor T7 serves as a second initialization transistor and may be electrically connected to the second scan line SL2, the second initialization voltage line VIL2, and the sixth transistor T6. The seventh transistor T7 is turned on according to a second scan signal GB transferred through the second scan line SL2 and is configured to transfer the second initialization voltage Vaint from the second initialization voltage line VIL2 to the first electrode of the light-emitting element LED, thereby initializing the first electrode of the light-emitting element LED.

In an embodiment, the ninth transistor T9 may be electrically connected to the second scan line SL2, the second electrode CE2 of the storage capacitor Cst, and the sustain voltage line VSL. The ninth transistor T9 may be turned on according to a second scan signal GB transferred through the second scan line SL2 and configured to transfer the sustain voltage VSUS to the second node N2, for example, the second electrode CE2 of the storage capacitor Cst during the initialization section and the data-write section.

In an embodiment, each of the eighth transistor T8 and the ninth transistor T9 may be electrically connected to the second node N2, for example, the second electrode CE2 of the storage capacitor Cst. In an embodiment, during the initialization section and the data-write section, the eighth transistor T8 may be turned off and the ninth transistor T9 may be turned on, and during an emission section, the eighth transistor T8 may be turned on and the ninth transistor T9 may be turned off. Because, during the initialization section and the data-write section, the sustain voltage VSUS is transferred to the second node N2, uniformity in brightness (e.g., long range uniformity (LRU)) of the display device corresponding to a voltage drop of the first voltage line VDDL may be improved.

In an embodiment, the storage capacitor Cst includes the first electrode CE1 and the second electrode CE2. The first electrode CE1 is electrically connected to the gate electrode of the first transistor T1, and the second electrode CE2 is electrically connected to the eighth transistor T8 and the ninth transistor T9.

In an embodiment, the auxiliary capacitor Ca may be electrically connected to the sixth transistor T6, the sustain voltage line VSL, and the first electrode of the light-emitting element LED. While the seventh transistor T7 and the ninth transistor T9 are turned on, the auxiliary capacitor Ca stores and maintains a voltage corresponding to a voltage difference between the first electrode of the light-emitting element LED and the sustain voltage line VSL, thereby preventing a black brightness from rising when the sixth transistor T6 is turned off.

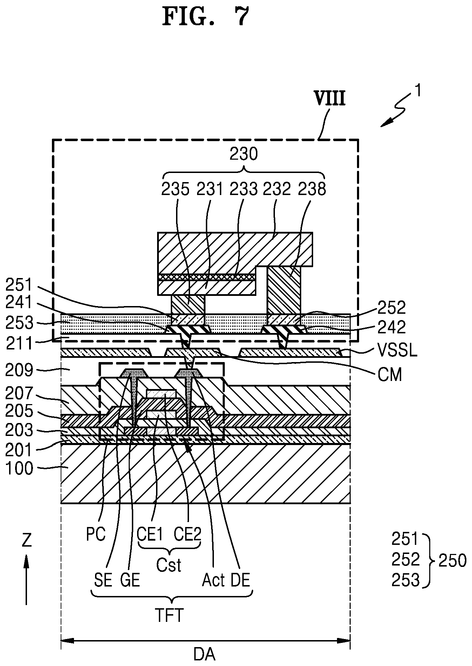

FIG. 7 is a cross-sectional view of the display area DA of the display device 1, according to an embodiment.

In an embodiment and referring to FIG. 7, the pixel driving circuit PC may be disposed on the substrate 100, and a light-emitting element 230 may be disposed on the pixel driving circuit PC.

In an embodiment, the substrate 100 may include polymer resin such as polyethersulfone, polyarylate, polyetherimide, polyethylene naphthalate, polyethylene terephthalate, polyphenylene sulfide, polyimide, polycarbonate, cellulose tri acetate, and cellulose acetate propionate. In an embodiment, the substrate 100 may include a single layer including the polymer resin. In another embodiment, the substrate 100 may have a multi-layered structure including a base layer and a barrier layer, wherein the base layer includes the above polymer resin and the barrier layer includes an inorganic insulating material. The substrate 100 including the polymer resin is flexible, rollable, or bendable.

In an embodiment, a buffer layer 201 may be disposed on the upper surface of the substrate 100. The buffer layer 201 may prevent impurities from penetrating a semiconductor layer of a transistor. The buffer layer 201 may include an inorganic insulating material such as silicon nitride, silicon oxynitride, and silicon oxide, and include a single layer or a multi-layer including the above inorganic insulating materials.

In an embodiment, the pixel driving circuit PC may be disposed on the buffer layer 201. FIG. 7 shows one of transistors TFT and a storage capacitor Cst included in the pixel driving circuit PC. The transistor TFT of FIG. 7 may correspond to one of the transistors described above with reference to FIGS. 6A to 6C.

In an embodiment, the transistor TFT may include a semiconductor layer Act on the buffer layer 201, and a gate electrode GE overlapping a channel region of the semiconductor layer Act. The semiconductor layer Act may include a silicon-based semiconductor material, for example, polycrystalline silicon. In another embodiment, the semiconductor layer Act may include an oxide-based semiconductor material. As an example, the semiconductor layer Act may include Zn-oxide-based material, for example, Zn-oxide, In-Zn oxide, and Ga-In-Zn oxide. The semiconductor layer Act may include In-Ga-Zn-O (IGZO), In-Sn-Zn-O (ITZO), or In-Ga-Sn-Zn-O (IGTZO) semiconductor containing metal such as indium (In), gallium (Ga), and stannum (Sn) in ZnO. The semiconductor layer Act may include a channel region, a drain region, and a source region, the drain region and the source region and being respectively on two opposite sides of the channel region.

In an embodiment, the gate electrode GE may include a conductive material including molybdenum (Mo), aluminum (Al), copper (Cu), and titanium (Ti) and have a single-layered structure or a multi-layered structure including the above materials. A first gate insulating layer 203 may be disposed under the gate electrode GE, wherein the first gate insulating layer 203 is for electrical insulation from the semiconductor layer Act. The first gate insulating layer 203 may include an inorganic insulating material such as silicon nitride, silicon oxynitride, and silicon oxide, and include a single layer or a multi-layer including the above inorganic insulating materials.

In an embodiment, the storage capacitor Cst may include the first electrode CE1 and the second electrode CE2 overlapping each other. The first electrode CE1 of the storage capacitor Cst may be disposed on the same layer as the gate electrode GE of the transistor TFT. In an embodiment, the first electrode CE1 of the storage capacitor Cst may include the gate electrode GE of the transistor TFT.

In an embodiment, a first interlayer insulating layer 205 may be disposed between the first electrode CE1 and the second electrode CE2 of the storage capacitor Cst. The first interlayer insulating layer 205 may include an inorganic insulating material such as silicon nitride, silicon oxynitride, and silicon oxide, and include a single-layered structure or a multi-layered structure including the above inorganic insulating materials.

In an embodiment, the second electrode CE2 of the storage capacitor Cst may include a conductive material of a low-resistance material such as molybdenum (Mo), aluminum (Al), copper (Cu) and/or titanium (Ti) and have a single-layered structure or a multi-layered structure including the above materials.

In an embodiment, a second interlayer insulating layer 207 may be disposed on the storage capacitor Cst. The second interlayer insulating layer 207 may include an inorganic insulating material such as silicon nitride, silicon oxynitride, and silicon oxide and include a single-layered structure or a multi-layered structure including the above inorganic insulating materials.

In an embodiment, an electrode, for example, an electrode (referred to as a source electrode SE, hereinafter) electrically connected to the source region of the semiconductor layer Act and/or an electrode (referred to as a drain electrode DE, hereinafter) electrically connected to the drain region of the semiconductor layer Act may be disposed on the second interlayer insulating layer 207. The source electrode SE and/or the drain electrode DE may be electrically connected to the semiconductor layer Act through a contact hole passing through the second interlayer insulating layer 207.

In an embodiment, the source electrode SE and/or the drain electrode DE may include aluminum (Al), copper (Cu), and/or titanium (Ti), and include a single layer or a multi-layer including the above materials.

In an embodiment, a first organic insulating layer 209 may be disposed on the second interlayer insulating layer 207. The first organic insulating layer 209 may include an organic insulating material. The organic insulating material may include acryl, benzocyclobutene (BCB), polyimide, or hexamethyldisiloxane (HMDSO).

In an embodiment, a connection layer CM may be disposed on the first organic insulating layer 209 and electrically connected to the transistor TFT. The connection layer CM may include aluminum (Al), copper (Cu), and/or titanium (Ti), and include a single layer or a multi-layer including the above materials.

In an embodiment, the second voltage line VSSL may be disposed on the first organic insulating layer 209. The second voltage line VSSL may include aluminum (Al), copper (Cu), and/or titanium (Ti), and include a single layer or a multi-layer including the above materials.

In an embodiment, a second organic insulating layer 211 may be disposed on the first organic insulating layer 209. The second organic insulating layer 211 may include an organic insulating material such as acryl, benzocyclobutene (BCB), polyimide, or hexamethyldisiloxane (HMDSO).

In an embodiment, a first electrode pad 241 and a second electrode pad 242 may be disposed on the second organic insulating layer 211. Each of the first electrode pad 241 and the second electrode pad 242 may include aluminum (Al), copper (Cu), and/or titanium (Ti), and include a single layer or a multi-layer including the above metal materials. As an example, each of the first electrode pad 241 and the second electrode pad 242 may be a double layer of a copper (Cu) layer and a titanium (Ti) layer. In another embodiment, each of the first electrode pad 241 and the second electrode pad 242 may include a layer including the above metal material and a layer including a transparent conductive oxide. As an example, each of the first electrode pad 241 and the second electrode pad 242 may include a layer including silver (Ag) and a layer including indium tin oxide (ITO). In an embodiment, each of the first electrode pad 241 and the second electrode pad 242 may have a structure in which a layer including silver (Ag) and a layer including ITO are alternately stacked.

In an embodiment, the light-emitting element 230 may be an inorganic light-emitting diode including an inorganic material. The light-emitting element 230 may include a first semiconductor layer 231, a second semiconductor layer 232, an intermediate layer 233 between the first semiconductor layer 231 and second semiconductor layer 232, a first electrode 235 electrically connected to the first semiconductor layer 231, and a second electrode 238 electrically connected to the second semiconductor layer 232. The first electrode 235 and the second electrode 238 of the light-emitting element 230 may be respectively and electrically connected to the first electrode pad 241 and the second electrode pad 242 disposed on the same layer (e.g., the second organic insulating layer 211).

In an embodiment, the first semiconductor layer 231 may include a p-type semiconductor layer. The p-type semiconductor layer may include a semiconductor material with a composition formula of InₓAl_{y}Ga_{1-x-y}N (0≤x≤1, 0≤y≤1, 0≤x+y≤1), such as GaN, AIN, AlGaN, InGaN, InN , InAlGaN, AlInN, and the like, and may be doped with a p-type dopant such as Mg, Zn, Ca, Sr, Ba, and the like.

In an embodiment, the second semiconductor layer 232 may include an n-type semiconductor layer. The n-type semiconductor layer may include a semiconductor material with a composition formula of InₓAl_{y}Ga_{1-x-y}N (0≤x≤1, 0≤y≤1, 0≤x+y≤1), such as GaN, AIN, AlGaN, InGaN, InN , InAlGaN, AlInN, and the like, and may be doped with n-type dopants such as Si, Ge, Sn, and the like.

In an embodiment, the intermediate layer 233 is a region where electrons and holes recombine. As the electrons and holes recombine, the intermediate layer 233 transitions to a lower energy level and may generate light having a corresponding wavelength. For example, the intermediate layer 233 may include a semiconductor material with a composition formula of InₓAl_{y}Ga_{1-x-y}N (0≤x≤1, 0≤y≤1, 0≤x+y≤1), and may be formed in a single quantum well structure or a multi quantum well structure (MQW). In addition, the intermediate layer 233 may include a quantum wire structure or a quantum dot structure.

In an embodiment, although it is described in FIG. 7 that the first semiconductor layer 231 includes a p-type semiconductor layer, and the second semiconductor layer 232 includes an n-type semiconductor layer, the embodiment is not limited thereto. In another embodiment, the first semiconductor layer 231 may include an n-type semiconductor layer, and the second semiconductor layer 232 may include a p-type semiconductor layer.

In an embodiment, a connector may be disposed between the first electrode 235 of the light-emitting element 230 and the first electrode pad 241 and between the second electrode 238 of the light-emitting element 230 and the second electrode pad 242. With regard to this, FIG. 7 shows a first connector 251 disposed between the first electrode pad 241 and the first electrode 235 of the light-emitting element 230, and a second connector 252 disposed between the second electrode pad 242 and the second electrode 238 of the light-emitting element 230.

In an embodiment, each of the first connector 251 and the second connector 252 may include an organic material including a first material. As an example, each of the first connector 251 and the second connector 252 may include an organic material including carbon black.

In an embodiment, the first connector 251 may be in direct contact with the first electrode pad 241 and the first electrode 235 of the light-emitting element 230. As an example, the bottom surface of the first connector 251 may be direct contact with the upper surface of the first electrode pad 241, and the upper surface of the first connector 251 may be direct contact with the bottom surface of the first electrode 235 of the light-emitting element 230.

In an embodiment, the second connector 252 may be in direct contact with the second electrode pad 242 and the second electrode 238 of the light-emitting element 230. As an example, the bottom surface of the second connector 252 may be direct contact with the upper surface of the second electrode pad 242, and the upper surface of the second connector 252 may be direct contact with the bottom surface of the second electrode 238 of the light-emitting element 230.

In an embodiment, an anti-reflection portion 253 may be disposed around the first connector 251 and the second connector 252. The anti-reflection portion 253 may include the same material as the first connector 251 and the second connector 252. In an embodiment, the anti-reflection portion 253 may include an organic material including the first material (e.g., carbon black). In an embodiment, the first connector 251, the second connector 252, and the anti-reflection portion 253 may include the first material (e.g., carbon black), a polymer such as acrylic resin, and a photoinitiator.

In an embodiment, the anti-reflection portion 253 includes the same material as the first connector 251 and the second connector 252, and may have different physical and/or electrical characteristics from those of the first connector 251 and the second connector 252. The anti-reflection portion 253 includes the organic material including the first material, and a density of the first material included in the anti-reflection portion 253 may be less than a density of the first material included in the first connector 251. Similarly, the density of the first material included in the anti-reflection portion 253 may be less than a density of the first material included in the second connector 252. As an example, the density of the first material included in the first connector 251 and/or the density of the first material included in the second connector 252 may be about twice or greater than the density of the first material included in the anti-reflection portion 253, and accordingly, an electrical conductivity of the first connector 251 and/or an electrical conductivity of the second connector 252 may be greater than an electrical conductivity of the anti-reflection portion 253.

In an embodiment, the anti-reflection portion 253 may be connected (e.g., integrally connected coupled) to the first connector 251 and the second connector 252. As an example, the anti-reflection portion 253 may be in direct contact with and integrally connected or coupled to the first connector 251 and the second connector 252. In other words, a first portion of an organic layer 250 including the first material that overlaps the first electrode pad 241 may correspond to the first connector 251, a second portion of the organic layer 250 that overlaps the second electrode pad 242 may correspond to the second connector 252, and a third portion of the organic layer 250 that does not overlap the first and second electrode pads 241 and 242 may correspond to the anti-reflection portion 253. Because the density of the first material included in each of the first connector 251 and the second connector 252 is greater than the density of the first material included in the anti-reflection portion 253, even though the anti-reflection portion 253 is connected (e.g., integrally connected or coupled) to the first connector 251 and the second connector 252, there is no concern about current leakage through the anti-reflection portion 253 while the light-emitting element 230 operates.

In an embodiment, the first material has conductivity and light absorption, and the first material of the organic layer 250 is dispersed in the organic material. By making the density of the first material included in the first connector 251 and/or the density of the first material included in the second connector 252 greater than the density of the first material included in the anti-reflection portion 253, the first and second electrode pads 241 and 242 may be electrically connected to the light-emitting element 230. Because the anti-reflection portion 253 including the first material overlaps elements under the anti-reflection portion 253, for example, the electrodes of the transistor TFT, the electrodes of the storage capacitor Cst, and/or wirings such as the second voltage line VSSL, the anti-reflection portion 253 may be configured to prevent or reduce unnecessary reflections due to the electrodes and/or wirings, and accordingly, light (e.g., unnecessary light reflected by the electrodes and/or wirings) other than light emitted from the light-emitting elements 230 may be prevented or reduced from being viewed by a user.

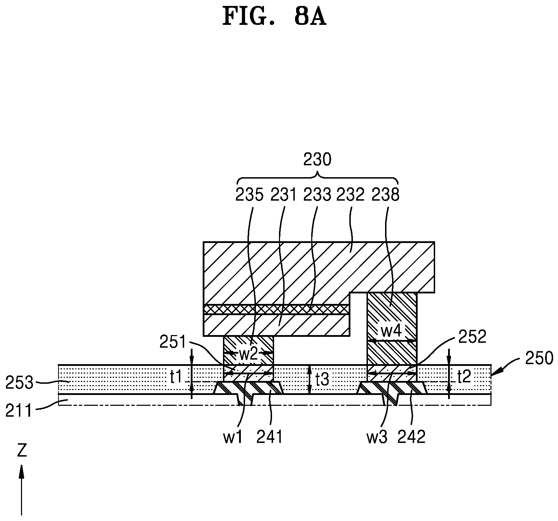

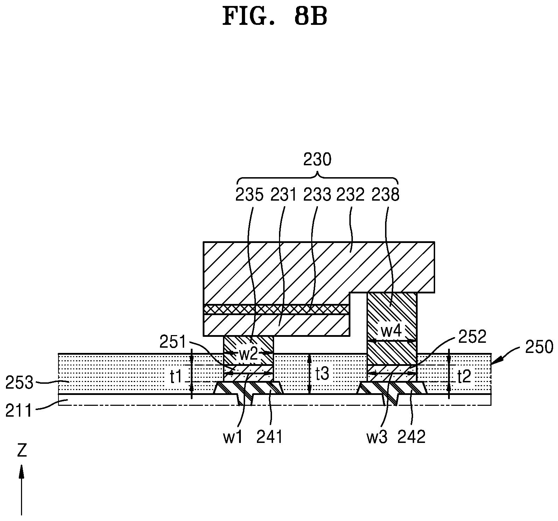

FIGS. 8A and 8B are cross-sectional views of the light-emitting element 230 and the organic layer 250 and correspond to a region VIII of FIG. 7, according to an embodiment.

In an embodiment and referring to FIGS. 8A and 8B, each of a first thickness t1 of the first connector 251 and a second thickness t2 of the second connector 252 may be different from a third thickness t3 of the anti-reflection portion 253. In an embodiment, each of the first thickness t1 of the first connector 251 and the second thickness t2 of the second connector 252 may be less than the third thickness t3 of the anti-reflection portion 253. In another embodiment, each of the first thickness t1 of the first connector 251 and the second thickness t2 of the second connector 252 may be substantially the same as the third thickness t3 of the anti-reflection portion 253.

In an embodiment, a first width w1 of the first connector 251 may be substantially the same as a second width w2 of the first electrode 235 of the light-emitting element 230. A third width w3 of the second connector 252 may be substantially the same as a fourth width w4 of the second electrode 238 of the light-emitting element 230.

In an embodiment, the upper surface of the first connector 251, the upper surface of the second connector 252, and the upper surface of the anti-reflection portion 253 may be arranged on the same plane. In other words, as shown in FIG. 8A, the upper surface of the first connector 251 and the upper surface of the second connector 252 may be arranged on substantially the same level as the upper surface of the anti-reflection portion 253.

In an embodiment, as shown in FIG. 8A, a first vertical distance from the upper surface of the second organic insulating layer 211 to the upper surface of the first connector 251 in a direction (e.g., z direction) perpendicular to the upper surface of the second organic insulating layer 211 may be substantially the same as a second vertical distance from the upper surface of the second organic insulating layer 211 to the upper surface of the anti-reflection portion 253 in the direction (e.g., z direction). Similarly, a third vertical distance from the upper surface of the second organic insulating layer 211 to the upper surface of the second connector 252 in a direction (e.g., z direction) perpendicular to the upper surface of the second organic insulating layer 211 may be substantially the same as the second vertical distance from the upper surface of the second organic insulating layer 211 to the upper surface of the anti-reflection portion 253 in the direction (e.g., z direction).

In another embodiment, the upper surface of the first connector 251 and the upper surface of the second connector 252 may be disposed on a plane different from the upper surface of the anti-reflection portion 253. In other words, as shown in FIG. 8B, the upper surface of the first connector 251 and the upper surface of the second connector 252 may be disposed on a level different from the upper surface of the anti-reflection portion 253.

In an embodiment, as shown in FIG. 8B, the first vertical distance from the upper surface of the second organic insulating layer 211 to the upper surface of the first connector 251 in a direction (e.g., z direction) perpendicular to the upper surface of the second organic insulating layer 211 may be less than the second vertical distance from the upper surface of the second organic insulating layer 211 to the upper surface of the anti-reflection portion 253 in the direction (e.g., z direction). Similarly, the third vertical distance from the upper surface of the second organic insulating layer 211 to the upper surface of the second connector 252 in a direction (e.g., z direction) perpendicular to the upper surface of the second organic insulating layer 211 may be less than the second vertical distance from the upper surface of the second organic insulating layer 211 to the upper surface of the anti-reflection portion 253 in the direction (e.g., z direction). Accordingly, a portion of the lateral surface of the first electrode 235 and a portion of the lateral surface of the second electrode 238 of the light-emitting element 230 may be in direct contact with the anti-reflection portion 253.

In an embodiment, although it is shown in FIG. 8B that the first vertical distance from the upper surface of the second organic insulating layer 211 to the upper surface of the first connector 251 in the direction (e.g., z direction) perpendicular to the upper surface of the second organic insulating layer 211 is less than the second vertical distance from the upper surface of the second organic insulating layer 211 to the upper surface of the anti-reflection portion 253 in the direction (e.g., z direction), the invention is not limited thereto. In another embodiment, the first vertical distance may be greater than the second vertical distance. In addition, the third vertical distance from the upper surface of the second organic insulating layer 211 to the upper surface of the second connector 252 in the direction (e.g., z direction) perpendicular to the upper surface of the second organic insulating layer 211 may be greater than the second vertical distance.

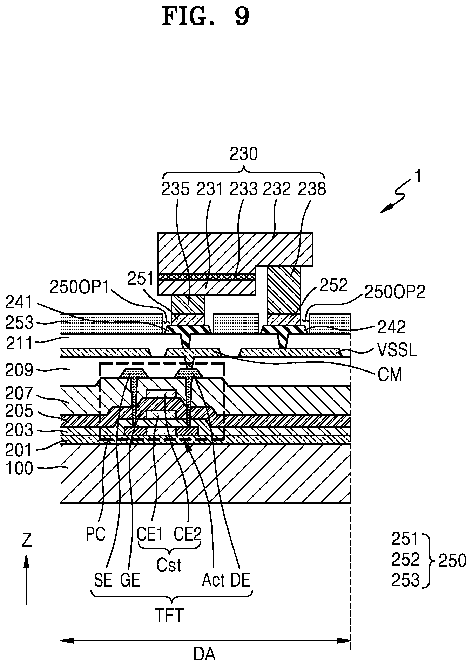

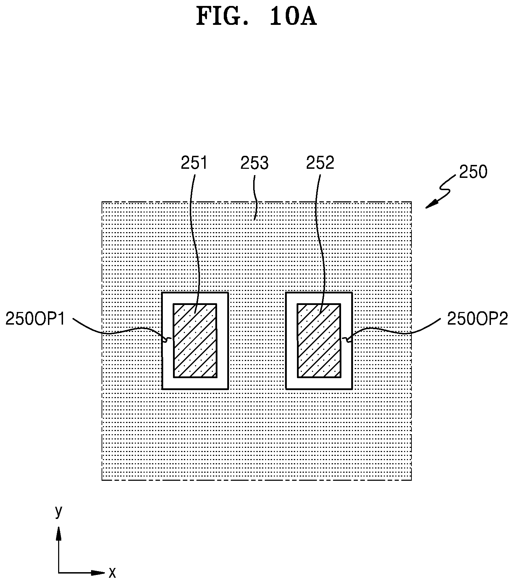

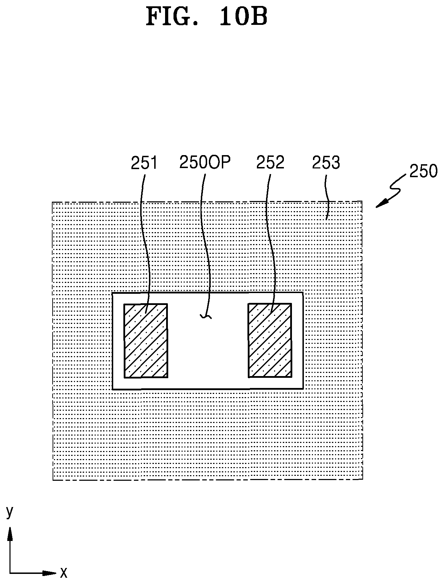

FIG. 9 is a cross-sectional view of the display device 1, according to an embodiment, FIG. 10A is an extracted plan view of the organic layer 250 shown in FIG. 9, according to an embodiment and FIG. 10B is an extracted plan view of the organic layer 250, according to an embodiment.

In an embodiment and referring to FIG. 9, the pixel driving circuit PC may be disposed on the substrate 100, and the light-emitting element 230 may be disposed on the pixel driving circuit PC. The specific structures of the substrate 100, the pixel driving circuit PC, the first electrode pad 241, the second electrode pad 242, and the light-emitting element 230 are the same as those described above.

In an embodiment, the organic layer 250 shown in FIG. 9 includes the first connector 251, the second connector 252, and the anti-reflection portion 253, wherein the anti-reflection portion 253 may be separated from the first connector 251 and the second connector 252. The characteristics of the first connector 251, the second connector 252, and the anti-reflection portion 253 of the organic layer 250 are the same as those described above with reference to FIGS. 7, 8A, and 8B. In an embodiment, the first connector 251, the second connector 252, and the anti-reflection portion 253 of the organic layer 250 include an organic material including the first material (e.g., carbon black), and physical and/or electrical characteristics of each of the first connector 251 and the second connector 252 may be different from physical and/or electrical characteristics of the anti-reflection portion 253. As an example, a density of the first material (e.g., carbon black) included in each of the first connector 251 and the second connector 252 may be greater than a density of the first material (e.g., carbon black) included in the anti-reflection portion 253. In an embodiment, the density of the first material (e.g., carbon black) included in each of the first connector 251 and the second connector 252 may be about twice or greater than the density of the first material (e.g., carbon black) included in the anti-reflection portion 253. An electrical conductivity of each of the first connector 251 and the second connector 252 may be greater than an electrical conductivity of the anti-reflection portion 253. The characteristics of the first thickness and width of the first connector 251, the second thickness and width of the second connector 252, and the third thickness of the anti-reflection portion 253 are the same as those described above with reference to FIGS. 8A and 8B. In addition, the upper surface of the first connector 251, the upper surface of the second connector 252, and the upper surface of the anti-reflection portion 253 may have the same level as that described with reference to FIG. 8A, or have a different level as described with reference to FIG. 8B.

In an embodiment and referring to FIGS. 9 and 10A, the organic layer 250 may include an opening (referred to as a first opening 250OP1, hereinafter) defining a separation region between the first connector 251 and the anti-reflection portion 253, and/or an opening (referred to as a second opening 250OP2, hereinafter) defining a separation region between the second connector 252 and the anti-reflection portion 253. The first opening 250OP1 of the organic layer 250 may have a closed loop shape surrounding the first connector 251 in a plan view, and the second opening 250OP2 of the organic layer 250 may have a closed loop shape surrounding the second connector 252 in a plan view.

In an embodiment, although it is shown in FIG. 10A that the organic layer 250 includes the first opening 250OP1 and the second opening 250OP2 respectively surrounding the first connector 251 and the second connector 252, and the first opening 250OP1 and the second opening 250OP2 are spaced apart from each other, the invention is not limited thereto. As shown in FIG. 10B, one opening 250OP may surround the first connector 251 and the second connector 252. In this case, there may not be a material corresponding to the anti-reflection portion 253 between the first connector 251 and the second connector 252.

In an embodiment where the first connector 251 and the second connector 252 are separated and spaced apart from the anti-reflection portion 253 as shown in FIGS. 10A and 10B, the above-described concern about leakage current may be structurally prevented.

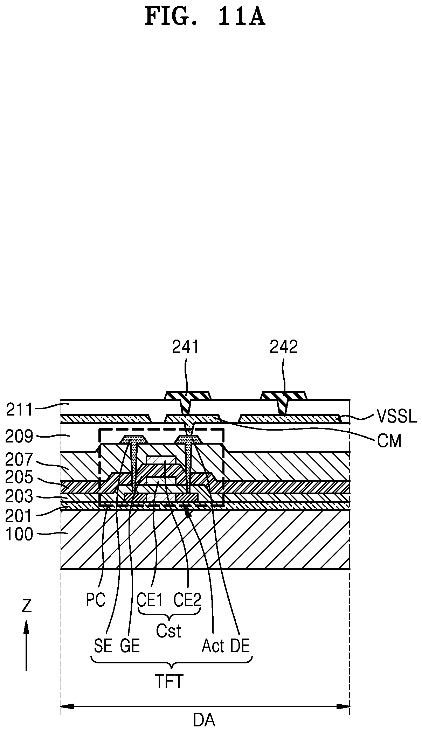

FIGS. 11A to 11E are schematic cross-sectional views showing a process of manufacturing the display device 1, according to an embodiment.

In an embodiment and referring to FIG. 11A, the first electrode pad 241 and the second electrode pad 242 are formed over the substrate 100. The first electrode pad 241 and the second electrode pad 242 may be arranged on the same layer, for example, the second organic insulating layer 211 and spaced apart from each other to be electrically insulated from each other. The first electrode pad 241 may be electrically connected to the transistor TFT, and the second electrode pad 242 may be electrically connected to the second voltage line VSSL.

In an embodiment, before the first electrode pad 241 and the second electrode pad 242 are formed, various layers may be formed on the substrate 100. As shown in FIG. 11A, the transistor TFT of the pixel driving circuit PC may be formed on the substrate 100.

In an embodiment, the substrate 100 may include a single layer including a polymer resin, or have a multi-layered structure including a base layer including a polymer resin and a barrier layer including an inorganic insulating material. The polymer resin may include polyethersulfone, polyarylate, polyetherimide, polyethylene naphthalate, polyethylene terephthalate, polyphenylene sulfide, polyimide, polycarbonate, cellulose tri acetate, and/or cellulose acetate propionate.

In an embodiment, a buffer layer 201 may be formed on the substrate 100, wherein the buffer layer 201 is formed to prevent impurities from penetrating to a semiconductor layer of the transistor TFT. The first gate insulating layer 203 for insulating the semiconductor layer of the transistor TFT from a gate electrode may be formed on the buffer layer 201, and the first interlayer insulating layer 205 between the first electrode CE1 and the second electrode CE2 of the storage capacitor may be formed on the first gate insulating layer 203. The second interlayer insulating layer 207 may be formed on the first interlayer insulating layer 205, and the first organic insulating layer 209 may be formed on the transistor TFT. The second voltage line VSSL may be formed on the first organic insulating layer 209, and the second organic insulating layer 211 may be formed on the second voltage line VSSL.

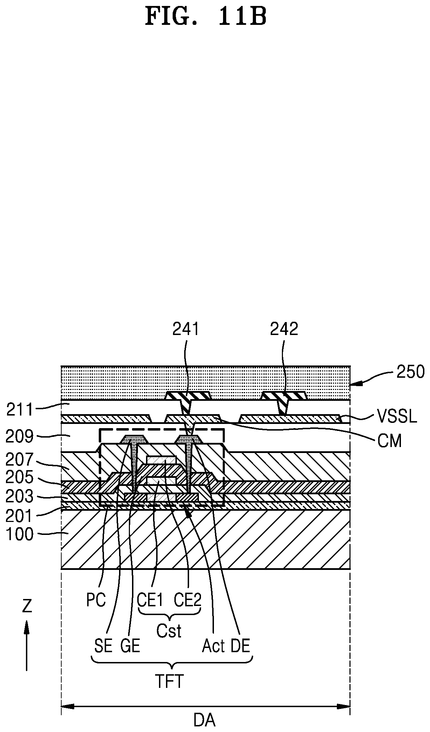

In an embodiment and referring to FIG. 11B, the organic layer 250 including the first material is formed on the first electrode pad 241 and the second electrode pad 242. The first material may be formed by coating an organic material including carbon black. The coated organic material may include the first material (e.g., carbon black), a polymer such as acrylic resin, and a photo inhibitor, and the above materials may be coated while mixed in a solvent. After the organic layer 250 is coated, pre-bake may be performed at a first temperature (e.g., about 100 °C). The organic layer 250 may be coated to overlap the upper surface of the substrate 100 entirely.

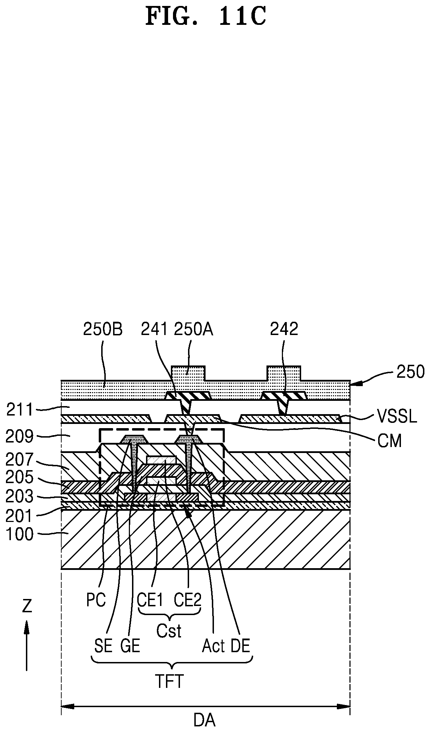

In an embodiment and referring to FIG. 11C, the organic layer 250 may be patterned. When exposure and developing are performed using a half-tone mask, the organic layer 250 may include a thick portion 250A that is relatively thick and a thin portion 250B that is relatively thin. The thick portions 250A may overlap the first electrode pad 241 and the second electrode pad 242.

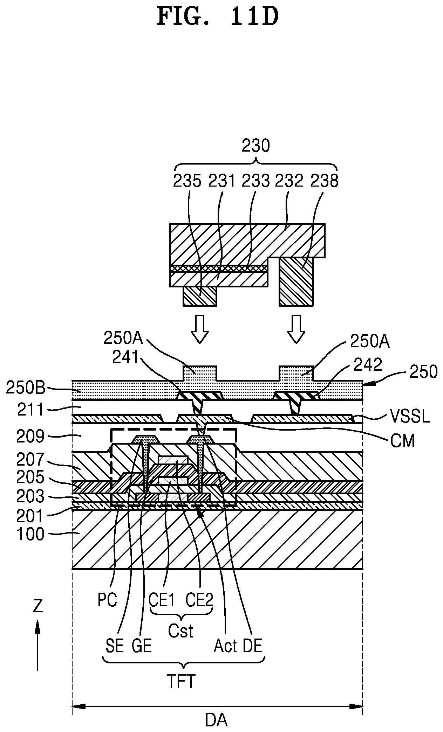

In an embodiment and referring to FIG. 11D, the light-emitting element 230 may be bonded to the organic layer 250. The first electrode 235 and the second electrode 238 of the light-emitting element 230 are arranged to face the organic layer 250, and then the light-emitting element 230 may be bonded by applying a preset pressure. The bonding of the light-emitting element 230 may be performed at a second temperature (e.g., about 120 °C). Then, the organic layer 250 may be hardened by performing curing at a third temperature (e.g., about 200 °C).

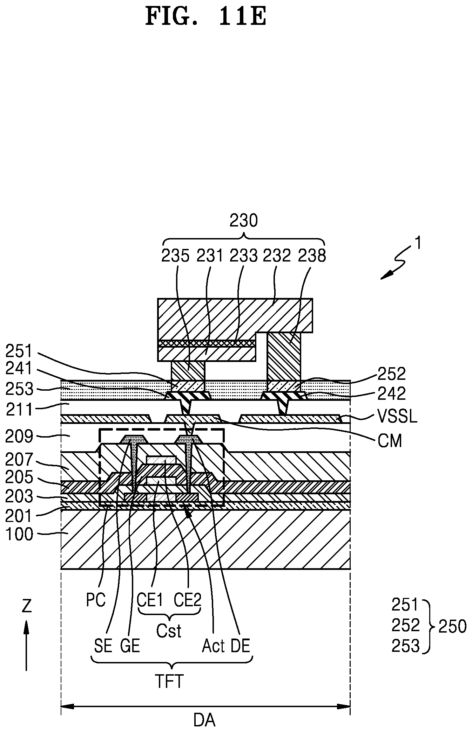

In an embodiment, by the pressure applied during the bonding process of the light-emitting element 230, as shown in FIG. 11E, the first connector 251 may be formed between the first electrode pad 241 and the first electrode 235 of the light-emitting element 230, and the second connector 252 may be formed between the second electrode pad 242 and the second electrode 238 of the light-emitting element 230.

In an embodiment, by the pressure applied during the bonding process of the light-emitting element 230, the thickness of the thick portion 250A (see FIG. 11C) of the organic layer 250 is reduced, and the first connector 251 and the second connector 252 may be formed. The thin portion 250B of the organic layer 250 to which the pressure is not applied may correspond to the anti-reflection portion 253. The thickness of each of the first connector 251 and the second connector 252 may be different from the thickness of the anti-reflection portion 253. As an example, as described with reference to FIG. 8A, the thickness of each of the first connector 251 and the second connector 252 may be less than the thickness of the anti-reflection portion 253. In another embodiment, the thickness of each of the first connector 251 and the second connector 252 may be equal to or greater than the thickness of the anti-reflection portion 253. The upper surface of each of the first connector 251 and the second connector 252 may be disposed on the same level as the upper surface of the anti-reflection portion 253 as described above with reference to FIG. 8A, or be disposed on a different level as described above with reference to FIG. 8B.

In an embodiment, due to the pressure applied during the bonding process, the density of the first material (e.g., carbon black) included in the first connector 251 may be greater than the density of the first material (e.g., carbon black) included in the anti-reflection portion 253 to which the pressure is not applied. Due to the pressure applied during the bonding process, the density of the first material (e.g., carbon black) included in the second connector 252 may be greater than the density of the first material (e.g., carbon black) included in the anti-reflection portion 253 to which the pressure is not applied. In an embodiment, the density of the first material (e.g., carbon black) included in the first connector 251 and/or the density of the first material (e.g., carbon black) included in the second connector 252 may be about twice or greater than the density of the first material (e.g., carbon black) included in the anti-reflection portion 253.

In an embodiment, due to the density difference of the first material, the first connector 251 may electrically connect the first electrode 235 of the light-emitting element 230 to the first electrode pad 241, and the second connector 252 may electrically connect the second electrode 238 of the light-emitting element 230 to the second electrode pad 242.

In an embodiment, although the process described with reference to FIGS. 11A to 11E includes a process of patterning the organic layer 250 to include the thick portion 250A and the thin portion 250B as shown in FIG. 11C, the invention is not limited thereto.

In another embodiment, the process of patterning the organic layer 250 described with reference to FIG. 11C may be omitted. The light-emitting element 230 may be disposed on the organic layer 250 shown in FIG. 11B, and in the case where the light-emitting element 230 is bonded with a preset pressure applied thereto, while the portions of the organic layer 250 that respectively overlap the first electrode 235 and the second electrode 238 of the light-emitting element 230 are pressed, the first connector 251 and the second connector 252 may be formed as shown in FIG. 8B.

In another embodiment, the process of patterning the organic layer 250 may include a process of forming an opening passing through the organic layer 250.

In an embodiment, the organic layer 250 may include a first opening of a closed loop shape surrounding a portion of the organic layer 250 that overlaps the first electrode pad 241, and a second opening of a closed loop shape surrounding a portion of the organic layer 250 that overlaps the second electrode pad 242. The portions of the organic layer 250 that overlap the first electrode pad 241 and the second electrode pad 242 are portions that serve as the first and second connectors 251 and 252, respectively, during the bonding process as described above. The first opening and the second opening of the organ layer 250 formed during the process of forming the opening may correspond to the first opening 250OP1 and the second opening 250OP2 surrounding the first and second connectors 251 and 252, respectively, as shown in FIG. 10A.

In another embodiment, the opening formed in the organic layer 250 may simultaneously surround a portion of the organic layer 250 that overlaps the first electrode pad 241 and a portion of the organic layer 250 that overlaps the second electrode pad 242. The portions of the organic layer 250 that overlap the first electrode pad 241 and the second electrode pad 242 are portions that serve as the first and second connectors 251 and 252, respectively, during the bonding process as described above. The opening of the organ layer 250 formed during the process of forming the opening may correspond to the opening 250OP surrounding the first and second connectors 251 and 252 as shown in FIG. 10B.

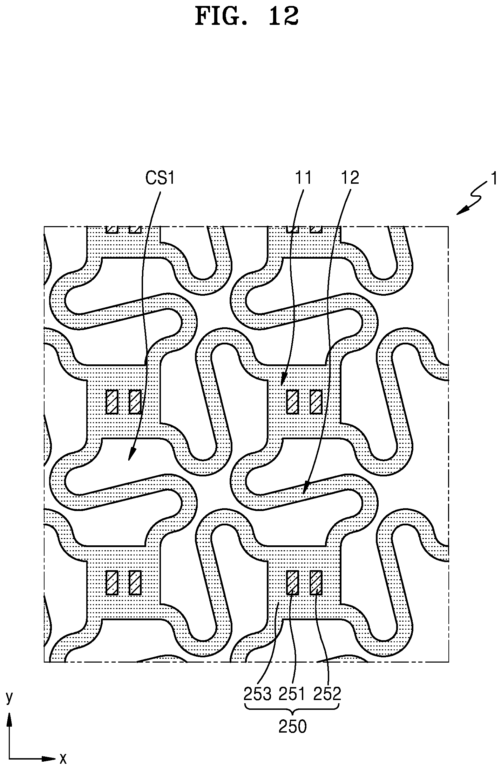

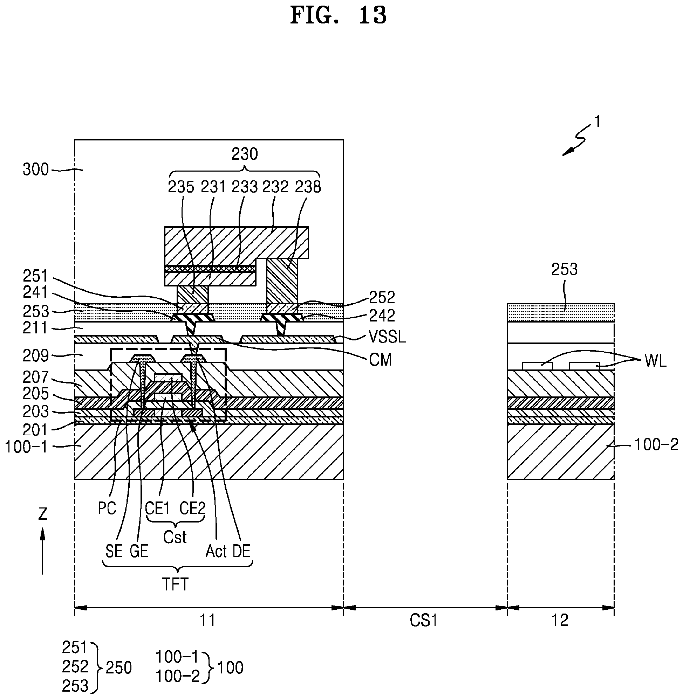

FIG. 12 is a schematic plan view of the display device 1, according to an embodiment, and FIG. 13 is a schematic cross-sectional view of the first island portion 11 and the first bridge portion 12 of the display device 1 of FIG. 12, according to an embodiment.

In an embodiment and referring to FIGS. 12 and 13, the connector may be arranged in the first island portion 11 in which the light-emitting element 230 (see FIG. 13) is arranged. As shown in FIG. 13, the substrate 100 may include a first island region 100-1 corresponding to the first island portion 11, and a first bridge region 100-2 corresponding to the first bridge portion 12. The pixel driving circuit PC is arranged in the first island region 100-1, and the light-emitting element 230 may be electrically connected to the first and second electrode pad 241 and 242 through the first connector 251 and the second connector 252, respectively.

In an embodiment, the anti-reflection portion 253 may cover the first island portion 11 that does not overlap the first connector 251 and the second connector 252, and extend toward the first bridge portion 12. The anti-reflection portion 253 may cover the first island region 100-1 of the substrate 100 that does not overlap the first connector 251 and the second connector 252 and extend toward the first bridge region 100-2. The wiring WL may be arranged in the first bridge region 100-2 of the substrate 100 and the wiring WL may be covered by the anti-reflection portion 253.

In an embodiment, the light-emitting element 230 may be covered by an encapsulation layer 300. The encapsulation layer 300 may include an inorganic encapsulation layer and/or an organic encapsulation layer. In an embodiment, the encapsulation layer 300 may have a structure in which an inorganic encapsulation layer including an inorganic insulating material, an organic encapsulation layer including an organic insulating material, and an inorganic encapsulation layer including an inorganic insulating material are stacked. In another embodiment, the encapsulation layer 300 may include an organic material such as resin. In an embodiment, the encapsulation layer 300 may include urethane epoxy acrylate. The encapsulation layer 300 may include a photosensitive material, for example, a photoresist.

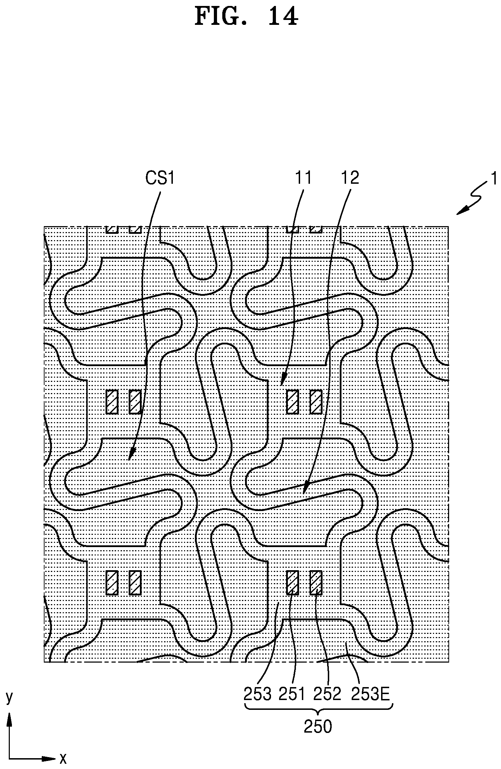

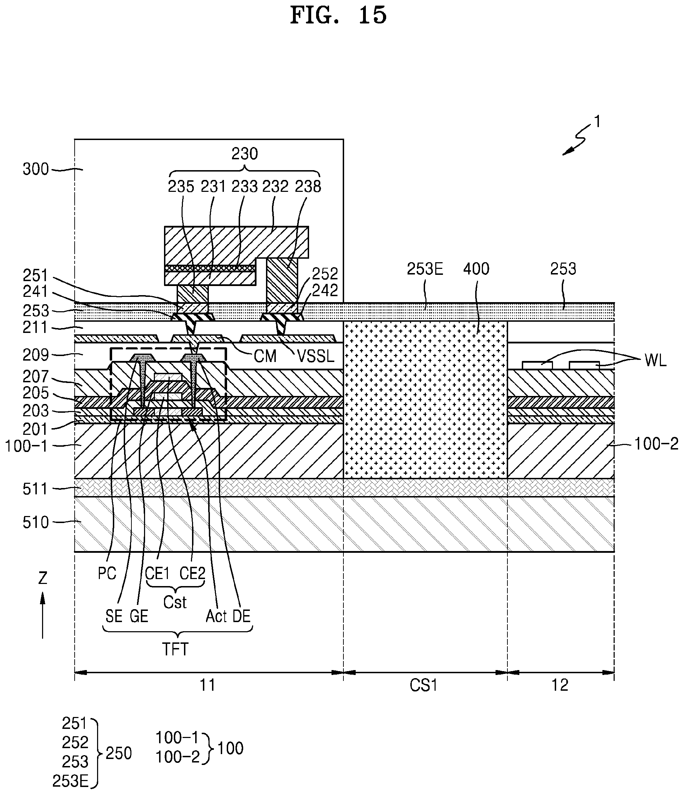

In an embodiment, the structures of the light-emitting element 230 and the organic layer 250 shown in FIG. 13, and the material of the organic layer 250 may be the same as the embodiment described above with reference to FIGS. 7 to 10B. Although it is shown in FIGS. 12 and 13 that the organic layer 250 including the first connector 251, the second connector 252, and the anti-reflection portion 253 has an opening region corresponding to the first opening CS1, the invention is not limited thereto. In another embodiment, the organic layer 250 may cover the first opening CS1 as shown in FIGS. 14 and 15 that will be described below.

FIG. 14 is a schematic plan view of the display device 1, according to an embodiment, and FIG. 15 is a schematic cross-sectional view of the first island portion 11 and the first bridge portion 12 of the display device 1 of FIG. 14, according to an embodiment.

In an embodiment, because the display device 1 shown in FIGS. 14 and 15 includes the same structure as the display device 1 described above with reference to FIGS. 12 and 13, the explanation of the same constructions will be replaced by a description referring to FIGS. 12 and 13, and hereinafter, differences such as an extension structure of the organic layer 250, a lower protective layer 510, a lower adhesive layer 511, and a filling layer 400 are mainly described.

In an embodiment, the display device 1 may include the lower protective layer 510 disposed below the substrate 100, and the lower adhesive layer 511 disposed between the substrate 100 and the lower protective layer 510. The lower protective layer 510 may support the substrate 100. The lower protective layer 510 may support the lower surface of each of the first island region 100-1 and the first bridge region 100-2 of the substrate 100 through the lower adhesive layer 511.

In an embodiment, the lower protective layer 510 may have a modulus that is equal or similar to that of the filling layer 400 described below. The modulus of each of the organic layer 250, the filling layer 400, and/or the lower protective layer 510 may be less than about 5 MPa. As an example, the modulus of each of the organic layer 250, the filling layer 400, and/or the lower protective layer 510 may be in a range of about 100 kPa to about 5 MPa. The lower protective layer 510 may include a stretched sheet. The lower protective layer 510 may include an elastomer film, a polydimethylsiloxane (PDMS) film, a silicone film, and the like.

In an embodiment, there may be the filling layer 400 disposed between the first island region 100-1 and the first bridge region 100-2 of the substrate 100, for example, in the first opening CS1. The filling layer 400 may have a modulus less than the modulus of the encapsulation layer 300. The modulus may denote an elastic modulus or a tension modulus. The filling layer 400 may include a material having physical properties that do not hinder the display device 1 from being transformed. The filling layer 400 may include an organic material having excellent stretchability. As an example, the filling layer 400 may include elastomer, polydimethylsiloxane (PDMS), ecoflex, organic silicone, and the like.

In an embodiment, the anti-reflection portion 253 of the organic layer 250 may cover the first opening CS1. An extension portion 253E of the anti-reflection portion 253 may extend to the first opening CS1. The extension portion 253E of the anti-reflection portion 253 may overlap the filling layer 400 arranged between the first island region 100-1 and the first bridge region 100-2, and thus may improve the quality of images displayed by the display device 1.

In an embodiment, the display device 1 may be used in various electronic apparatuses capable of displaying images. Here, the electronic apparatuses denote apparatuses that use electricity and that may display preset images.

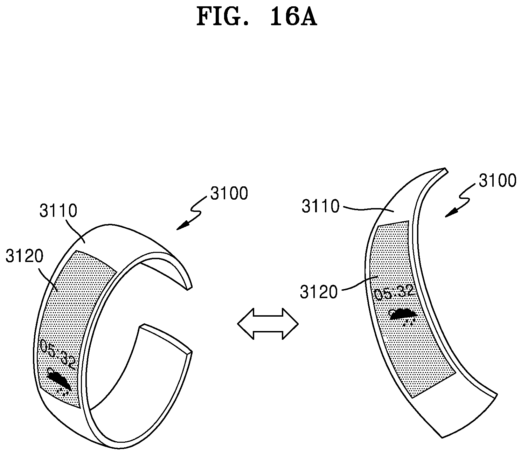

FIGS. 16A to 16G are schematic perspective views of embodiments of an electronic apparatus including the display device, according to an embodiment.

In an embodiment and referring to FIG. 16A, the display device according to an embodiment may be utilized in a wearable electronic apparatus 3100 that may be worn on a portion of a user's body. The wearable electronic apparatus 3100 may include a body portion 3110 and a display 3120 provided to the body portion 3110. The display device according to embodiments may be used as the display 3120 of the wearable electronic apparatus 3100. As shown in FIG. 16A, the wearable electronic apparatus 3100 may be transformed. In an embodiment, the wearable electronic apparatus 3100 may be used as a smartwatch or a smartphone depending on a user's selection.

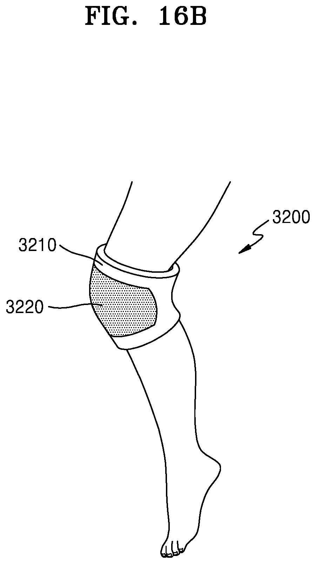

In an embodiment, FIG. 16B shows a medical electronic apparatus 3200. In an embodiment, the medical electronic apparatus 3200 may include a body portion 3210 and an emission portion 3220. The display device according to embodiments may be used as the emission portion 3220 of the medical electronic apparatus 3200. The emission portion 3220 may be configured to emit light in a preset wavelength band (e.g., an infrared ray, a visible ray, and the like) to a patient's body. In an embodiment, the body portion 3210 may include a stretchable fiber material and may have a structure that may be worn on the body of the user who uses the emission portion.

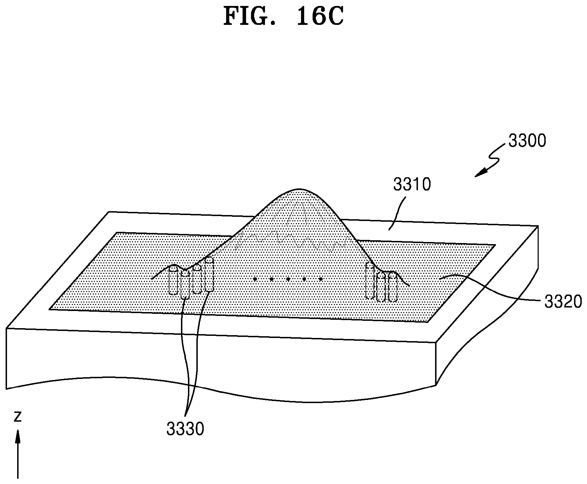

In an embodiment, FIG. 16C shows an educational electronic device 3300. In an embodiment, the educational electronic device 3300 may include a display 3320 provided inside a frame 3310. The display 3320 may use the display device according to embodiments. Images such as sea with waves, a mountain covered with snow, or a volcano with flowing lava may be provided through the display 3320, and in this case, the display 3320 may extend in the height direction (e.g., a z direction) to reflect the height of waves, mountains, or volcanoes. In an embodiment, because a portion of the display 3320 may show the movements of lava three dimensionally by sequentially changing its height in a direction in which the lava flows. The educational electronic apparatus 3300 may include a plurality of pins 3330 (or stroke portions) disposed on the backside of the display 3320 such that the display 3320 extends in a height direction. As the pins 3330 move in the third direction (e.g., a z direction or a -z direction), the image displayed on the display 3320 may be implemented to have a three-dimensional height. Although FIG. 16C describes the educational electronic apparatus 3300, the purpose of the electronic apparatus is not limited as long as the electronic apparatus provides preset image information.

In an embodiment, although the electronic apparatuses shown in FIGS. 16A to 16C are described as electronic apparatuses whose shapes are variable, the invention is not limited thereto. In an embodiment, the display device may be used in an electronic apparatus in which a portion (e.g., a screen) capable of displaying images is fixed.

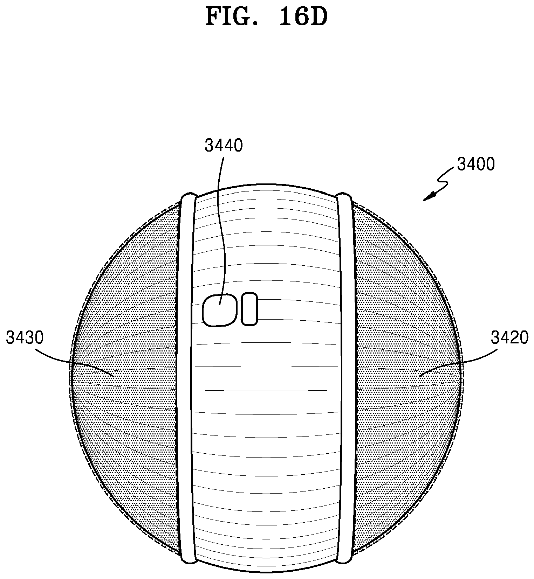

FIG. 16D shows a robot 3400 as an electronic apparatus, according to an embodiment. The robot 3400 may move or recognize an object by using a camera portion 3440 and display preset images to a user through displays 3420 and 3430. In an embodiment, because the display devices according to an embodiment may be stretched in various directions as described above, the display devices may be assembled to a body frame having a hemispherical shape, and thus, the robot 3400 may include the displays 3420 and 3430 having a hemispherical shape.

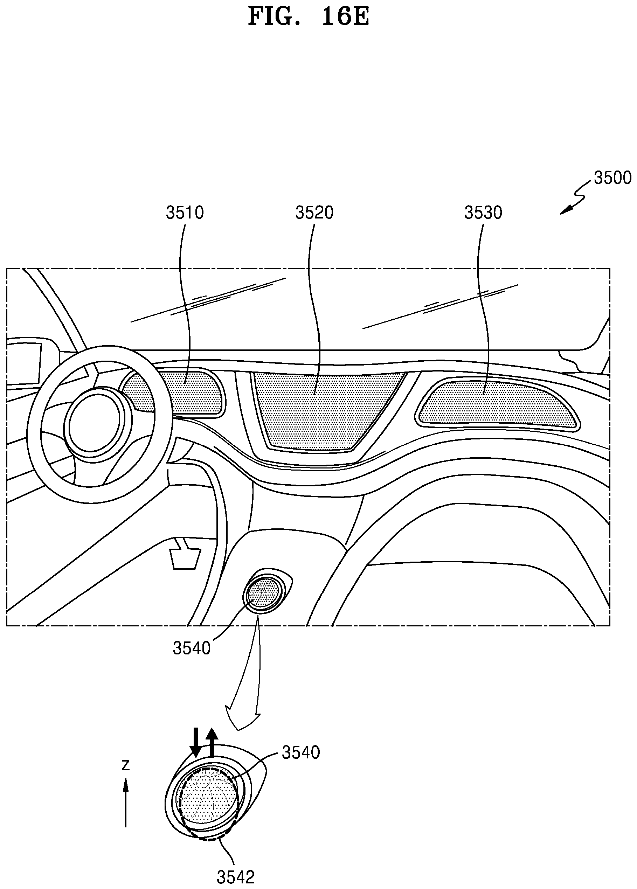

FIG. 16E shows a vehicle display device 3500 as another electronic apparatus, according to an embodiment. The vehicle display device 3500 may include a cluster 3510, a center information display (CID) 3520, and/or a co-driver display 3530. Because the display device according to an embodiment may be stretched in various directions, the display device may be used as the cluster 3510, the CID 3520, and/or a co-driver display 3530 regardless of the shape of an internal frame of the vehicle.

In an embodiment, although it is shown in FIG. 16E that the cluster 3510, the CID 3520, and/or the co-driver display 3530 are separated from each other, the invention is not limited thereto. In another embodiment, two or more of the cluster 3510, the CID 3520, and/or the co-driver display 3530 may be integrally connected or coupled.

In an embodiment, the vehicle display device 3500 may include a button 3540 that may display preset images. Referring to an enlarged view of FIG. 16E, the button 3540 having a hemispherical shape may include an object 3542 that provides the feeling of using the button while moving in the z direction or -z direction, and a display device disposed on the object 3542. In an embodiment, in the case where the object 3542 has a surface rounded three-dimensionally, the display device may also have a surface rounded three-dimensionally.

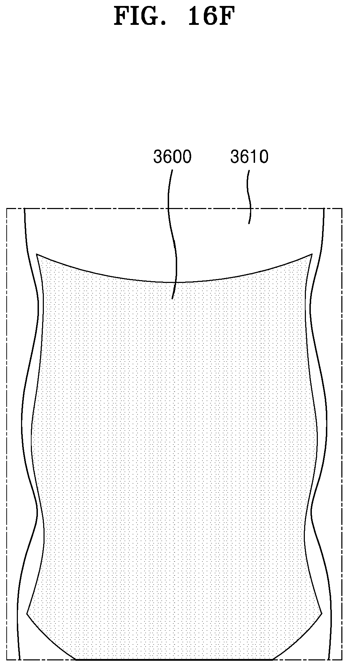

FIG. 16F shows that the electronic apparatus, according to an embodiment, is an electronic apparatus 3600 for advertising or exhibition. In an embodiment, the electronic apparatus 3600 for advertising or exhibition may be installed at a structure 3610 such as a wall or pillar. In the case where the structure 3610 includes an uneven surface as shown in FIG. 16F, the electronic apparatus 3600 for advertising or exhibition may be also disposed along the uneven surface of the structure 3610. In an embodiment, the electronic apparatus 3600 for advertising or exhibition may be installed at the structure 3610 using a heat shrink film and the like.

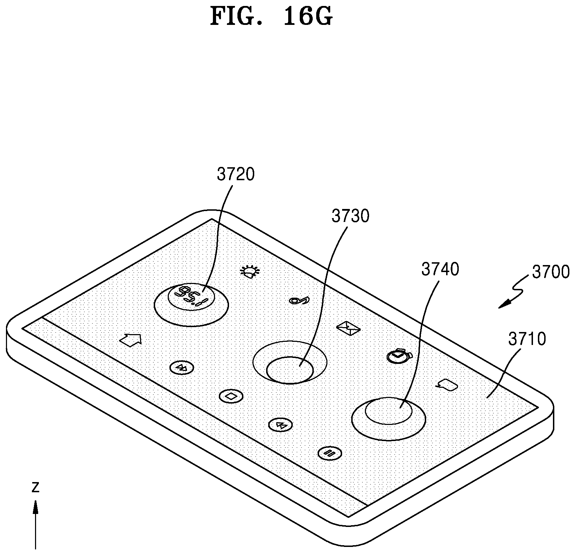

FIG. 16G shows that the electronic apparatus, according to an embodiment, is a controller 3700. The controller 3700 may include an image type button. As an example, the controller 3700 may include first to third bottom regions 3720, 3730, and 3740 in which a partial region of a display 3710 protrudes in a z direction or -z direction (or collapses in the z direction). In an embodiment, the first and third button regions 3720 and 3740 may protrude in the z direction, and the second button region 3730 may protrude in the -z direction (or collapse in the z direction).

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the invention. Moreover, the embodiments or parts of the embodiments may be combined in whole or in part without departing from the scope of the invention.

## Claims

1. A display device comprising:
a substrate;
a transistor disposed on the substrate;
a first electrode pad electrically connected to the transistor;
a first connector disposed on the first electrode pad;
an anti-reflection portion arranged around the first connector; and
a light-emitting element electrically connected to the first electrode pad through the first connector,
wherein each of the first connector and the anti-reflection portion includes a first material, and a density of the first material included in the first connector is greater than a density of the first material included in the anti-reflection portion.

2. The display device of claim 1, wherein the density of the first material included in the first connector is greater than or equal to about twice the density of the first material included in the anti-reflection portion.

3. The display device of claim 1, wherein each of the first connector and the anti-reflection portion includes an organic material in which the first material is mixed.

4. The display device of claim 1, wherein the first material includes a carbon black.

5. The display device of claim 1, wherein an electrical conductivity of the first connector is greater than an electrical conductivity of the anti-reflection portion.

6. The display device of claim 1, wherein the first connector and the anti-reflection portion are coupled to each other.

7. The display device of claim 1, wherein the first connector is spaced apart from the anti-reflection portion, and wherein a separation region is disposed between the first connector and the anti-reflection portion to entirely surround the first connector in a plan view.

8. The display device of claim 1, further comprising:
a second electrode pad arranged around the first electrode pad; and
a second connector connecting the second electrode pad to the light-emitting element, and including the first material,
wherein a density of the first material included in the second connector is greater than the density of the first material included in the anti-reflection portion.

9. The display device of claim 8, wherein the substrate includes:
an island region in which the light-emitting element is arranged; and
a bridge region connecting the island region to an adjacently disposed island region, wherein the anti-reflection portion extends to the bridge region.

10. A display device comprising:
a substrate;
a transistor disposed on the substrate;
a first electrode pad electrically connected to the transistor;
a second electrode pad disposed adjacent to the first electrode pad;
a light-emitting element disposed on the first electrode pad and the second electrode pad and electrically connected to the first electrode pad and the second electrode pad; and
an organic layer disposed between the first electrode pad and the light-emitting element and between the second electrode pad and the light-emitting element, and including a first material,
wherein the organic layer includes a first portion overlapping the first electrode pad, a second portion overlapping the second electrode pad, and a third portion not overlapping the first electrode pad and the second electrode pad, and
wherein the first portion electrically connects the first electrode pad to the light-emitting element, and the second portion electrically connects the second electrode pad to the light-emitting element.

11. The display device of claim 10, wherein a density of the first material included in the first portion is greater than a density of the first material included in the third portion, and a density of the first material included in the second portion is greater than the density of the first material included in the third portion.

12. The display device of claim 11, wherein an electrical conductivity of the first portion is greater than an electrical conductivity of the third portion.

13. The display device of claim 11, wherein the density of the first material included in the first portion is greater than or equal to about twice the density of the first material included in the third portion, and the density of the first material included in the second portion is greater than or equal to about twice the density of the first material included in the third portion.

14. The display device of claim 10, wherein the first material includes a carbon black.

15. The display device of claim 10, wherein the first portion is in contact with the third portion.

16. The display device of claim 10, wherein the organic layer includes an opening that entirely surrounds the first portion in a plan view.

17. The display device of claim 10, wherein the substrate includes:
an island region in which the light-emitting element is arranged; and
a bridge region connecting the island region to an adjacent island region,
wherein the third portion extends to the bridge region.

18. A method of manufacturing a display device, the method comprising:
forming a transistor over a substrate;
forming a first electrode pad electrically connected to the transistor, and a second electrode pad adjacent to the first electrode pad;
forming an organic layer including a first material on the first electrode pad and the second electrode pad;
disposing a light-emitting element on the organic layer to overlap the first electrode pad and the second electrode pad; and
applying a pressure to the light-emitting element such that the light-emitting element is electrically connected to the first electrode pad and the second electrode pad,
wherein, in the applying of the pressure, the organic layer includes
a first portion, a second portion, and a third portion, wherein the first portion overlaps the first electrode pad and electrically connects the first electrode pad to the light-emitting element, the second portion overlaps the second electrode pad and electrically connects the second electrode pad to the light-emitting element, and the third portion does not overlap the first electrode pad and the second electrode pad, and
wherein a density of the first material included in the first portion is greater than a density of the first material included in the third portion, and
a density of the first material included in the second portion is greater than the density of the first material included in the third portion.

19. The method of claim 18, wherein an electrical conductivity of the first portion is greater than an electrical conductivity of the third portion, and an electrical conductivity of the second portion is greater than the electrical conductivity of the third portion.

20. The method of claim 18, wherein the forming of the organic layer comprises patterning the organic layer such that thicknesses of portions of the organic layer overlapping the first electrode pad and the second electrode pad are greater than a thickness of the other portion of the organic layer.

21. The method of claim 18, wherein the forming of the organic layer comprises forming a first opening and a second opening, wherein the first opening surrounds a portion of the organic layer that overlaps the first electrode pad, and the second opening surrounds a portion of the organic layer that overlaps the second electrode pad.

22. The method of claim 18, wherein the forming of the organic layer comprises forming a single opening surrounding a portion of the organic layer that overlaps the first electrode pad and a portion of the organic layer that overlaps the second electrode pad.

23. The method of claim 18, wherein the first material includes a carbon black.

24. The method of claim 18, wherein the first portion is coupled to the third portion.

25. The method of claim 18, wherein the substrate includes:
an island region in which the light-emitting element is arranged; and
a bridge portion connecting the island portion to an adjacent island portion, and
the forming of the organic layer comprises coating the organic layer to be arranged in the island portion and the bridge portion.
